# EUROPEAN PATENT APPLICATION

(11) **EP 4 672 917 A2**
(43) Date of publication of application: **31.12.2025**
(21) Application number: 25185033.5
(22) Date of filing: 24.06.2025
(51) Int. Cl.: H10D 84/01, H10D 30/00, H10D 64/23, H10D 84/83

(54) **BACKSIDE ETCH PROCESSES FOR ULTRA UNIFORMITY OF FRONT-END STRUCTURES**

(30) Priority: 28.06.2024 US 202418759234
(71) Applicant: INTEL Corporation, Santa Clara, CA 95054 (US)
(72) Inventor: ZHANG, Feng, Portland, 97229 (US); XU, Guowei, Portland, 97229 (US); CHU, Tao, Portland, 97229 (US); YEUNG, Chun Wing, Portland, 97229 (US); ZHANG, Kan, Hillsboro, 97123 (US); MURTHY, Anand, Portland, 97229 (US); HUNG, Ting-Hsiang, Santa Clara, 95051 (US); CHAO, Robin, Portland, 97209 (US); ZHANG, Yang, Rio Rancho, 87124 (US); PACKAN, Paul A., Hillsboro, 97124 (US); LUO, Yanbin, Portland, 97229 (US); LIN, Chung-Hsun, Portland, 97229 (US); LIN, Chia-Ching, Portland, 97229 (US); JANG, Minwoo, Portland, 97229 (US)
(74) Representative: 2SPL Patentanwälte PartG mbB

(57) **Abstract**

Isolation structures between transistors in integrated circuit (IC) devices. An IC device includes transistors coupled to an interconnect network, and between the transistors a dielectric structure with a wider width away from the interconnect network and a narrower width nearer the interconnect network. Dielectric structures with wider back-side widths may separate gate electrodes and/or source and drain contacts of the transistors. The dielectric structures may be formed by etching an opening between metallization structures of the transistors from a back side of the device substrate and by depositing liner and fill dielectrics over the back-side opening.

## Description

### BACKGROUND

As transistors dimension are scaled down, yield, performance, and reliability issues may be introduced due to tapered etching and non-uniform contours. An etched opening may widen as the etch continues (e.g., in time and/or depth). Etches performed from a wafer front-side during front-end-of-line (FEOL) processing (e.g., with a significant number of operations to follow) may have an excessively wide front-side opening, particularly for a necessarily deep etch between dimensionally constrained features. For example, an isolation etch through a metal gate structure or between trench contacts, needing to be both deep and wide enough to sufficiently isolate adjacent transistors while tapering to a narrowest width at an etch front (and widening at the etch surface), will often wear away or erode metallization adjacent to, or at an edge of, the etch. The resultant rounding (e.g., from erosion or tapering) introduces process variation, for example, as the rounding is affected by local micro-loading differences (e.g., near to or away from other structures or etches), and may reduce yield and/or performance. Excessive erosion or tapering may impact device reliability.

Front-side, e.g., FEOL, processing (such as dielectric filling of metal gate and contact cuts to form isolation structures) may be constrained by subsequent processing. Etch selectivities may be required and so limit available materials for features to be exposed to ensuing operations. For example, an optimal dielectric for a certain feature may not be available due to a later etch during front- or back-end processing.

New techniques and structures are needed to enable enhanced isolation, to minimize tapering or eroding of device features, to improve feature uniformity, and to reduce process variation.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, and 1C illustrate cross-sectional profile views of an integrated circuit (IC) device having isolation structures between and separating transistor structures between front- and back-side interconnect metallization networks, in accordance with some embodiments;
FIGS. 2A and 2B illustrate front- and back-side plan views of an IC device having regular arrays of gate structures and channel regions, in accordance with some embodiments;
FIG. 3 is a flow chart of methods for forming a dielectric structure between transistor structures from a back-side of a substrate, in accordance with some embodiments;
FIGS. 4A, 4B, 5A, 5B, 6A, 6B, 7A, 7B, 8A, 8B, 9A, 9B, 10A, 10B, 11A, 11B, 12A, 12B, 13A, and 13B illustrate cross-sectional profile views of an IC device having improved dielectric structures between structures, at various stages of manufacture, in accordance with some embodiments;
FIG. 14 illustrates a diagram of an example data server machine employing an IC device having isolation structures formed from a back side of a substrate, in accordance with some embodiments; and
FIG. 15 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Structures, techniques, and materials are disclosed to improve the performance, yields, and reliability of integrated circuit (IC) devices having isolation structures between adjacent transistors.

Improved isolation structures may be formed from a wafer or die back-side. Rather than etching through and between metal gates and transistor contacts from a densely populated side of a device substrate (e.g., a device front-side), metal gate and contact cuts are made from an opposite side of the device (e.g., away from a dense grid of metallization). For example, a narrower etch front of a gate or contact cut may separate metallization features in adjacent transistors, and a wider, flared etch opening may be on a back-side, where ample space is available for isolations between transistors.

A back-side, back-end-of-line (BEOL) isolation etch may allow for the front-end-of-line (FEOL) fabrication of a dense and uniform contact and interconnect network on a front-side that BEOL isolation etches may then separate as desired. A back-side, BEOL isolation etch, having fewer operations to follow (and following the fabrication of front-side contact and interconnect networks), also minimizes the introduction of process variation (particularly process variation in the front-side networks).

Having fewer subsequent operations may also remove material constraints, e.g., on structures between and isolating transistors. For example, a low-permittivity ("low-K") or etch-resistant dielectric that may not be available for an early, FEOL operation (e.g., due to a subsequent etch) may be used at a later, BEOL operation. These additional material availabilities may enable improved performance and yield, for example, by reducing parasitic capacitances and/or providing beneficial strains to adjacent structures.

Improved isolation structures may separate transistors coupled to a front-side interconnect network and may be wider on a substrate back-side and taper to a narrower front-side width. Improved isolation structures may have a dielectric core (e.g., of a low-K material) in a dielectric liner (e.g., of an etch-resistant or otherwise protective material).

Improved isolation structures separating metallization structures (e.g., formed by a dielectric fill of a metal gate or contact cut) may be part of an integrated isolation scheme including other isolation structures formed from, for example, a substrate back-side following removal of a semiconductor or insulator base (e.g., under a device layer and built-up interconnect layers). Back-side access may enable other isolation structures, for example, in place of source or drain regions. Some or all of improved isolation structures may be continuous, e.g., with a common dielectric liner and dielectric fill (for example, in a core within the liner).

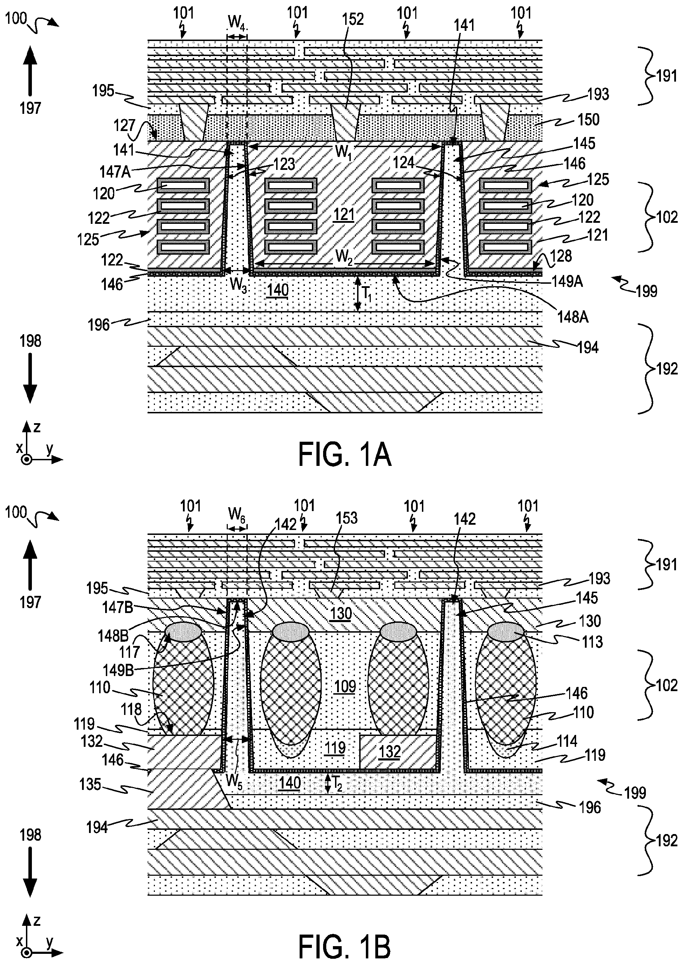

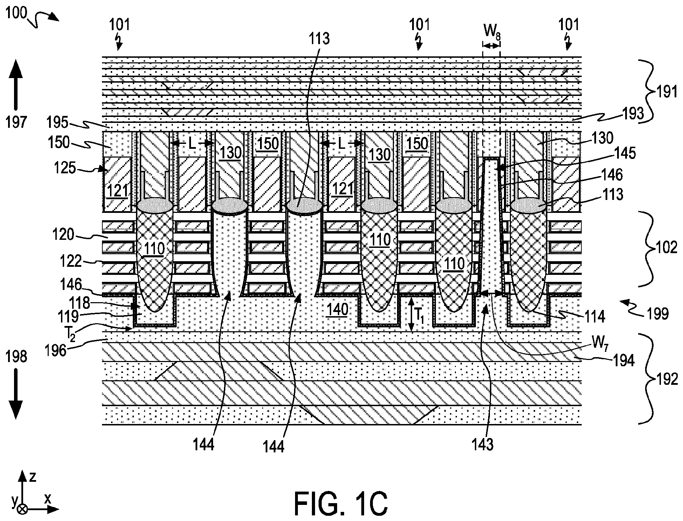

FIGS. 1A, 1B, and 1C illustrate cross-sectional profile views of an IC device 100 having isolation structures 141, 142, 143, 144 between and separating transistor structures 101 between front- and back-side interconnect metallization networks 191, 192, in accordance with some embodiments. Isolation structures 141, 142, 143, 144 are dielectric structures that provide electrical isolation between conductive structures, e.g., elements of transistor structures 101. FIGS. 1A and 1B show parallel cross-sections in y-z viewing planes (e.g., offset in an x-direction) through transistor structures 101. FIG. 1A illustrates a cross-section through channel regions 102 (e.g., nanoribbons 120) and gate structures 125 (having gate metal 121 and gate insulator 122). FIG. 1B shows a cross-section through source or drain regions 110, e.g., coupled to nanoribbons 120 of FIG. 1A. FIG. 1C illustrates a cross-section in an x-z viewing plane through source or drain regions 110, nanoribbons 120, and gate structures 125 of transistor structures 101.

In the examples of FIGS. 1A-1C, interconnect network 191 is on a front-side 197 of substrate 199, and transistor structures 101 are coupled to a first interconnect metallization level 193 in front-side interconnect metallization network 191. In some embodiments, transistor structures 101 are coupled to a second interconnect metallization level 194 in back-side interconnect metallization network 192 on a back-side 198 of substrate 199. In some embodiments, back-side interconnect network 192 is absent in substrate 199. In many embodiments, transistor structures 101 are fabricated on front-side 197 of substrate 199 before interconnect metallization network 191 is built up over structures 101 and interconnect metallization network 192 is built up on back-side 198 of substrate 199, but the use of front- and back-sides 197, 198 to describe opposing first and second sides 197, 198 of substrate 199 do not imply any particular method necessary for fabrication of all embodiments of device 100.

FIG. 1A shows IC apparatus or device 100 having isolation structures 141 between gate structures 125 and between first and second interconnect metallization levels 193, 194. Transistor structures 101 each include channel regions 102 extending through gate structures 125. Metallization levels 193, 194 are on opposing front- and back-sides 197, 198 of substrate 199. Metallization levels 193 are in insulator layers 195 on front-side 197 of substrate 199. Insulator layers 195 are between metallization levels 193. Metallization levels 194 are in insulator layers 196 on back-side 198 of substrate 199. Insulator layers 196 are between metallization levels 194. Insulator layer 195 is between insulator layer 150 and interconnect metallization level 193. Gate structure 125 in transistor structure 101 is between first and second interconnect metallization levels 193, 194. Transistor structure 101 and gate structure 125 are coupled to metallization level 193 in front-side network 191 at least by gate contact or via 152. Other contacts or vias (not shown, e.g., in front or behind the viewing plane) may couple structures 101 to one or both of levels 193, 194 in networks 191, 192.

Gate structure 125 is around channel region 102 and includes gate metal 121 and gate insulator 122, with insulator 122 on and around channel region 102 and metal 121 on and around insulator 122. Channel regions 102 with a shared gate structure 125 may be in the same or different transistor structures 101. In some embodiments, as in the example of FIG. 1A, gate structure 125 includes insulator 122 on a back-side 128, 198 of structure 125. In the example of FIG. 1A, channel region 102 includes nanoribbons 120 in a stack. Nanoribbons 120 may be as wide or narrow as is suitable for a given embodiment. In some embodiments, nanoribbons 120 are sufficiently wide to be characterized as nanosheets. In some embodiments, nanoribbons 120 are sufficiently narrow to be characterized as nanowires. Channel region 102 may include any suitable structure(s). In some embodiments, channel region 102 includes a fin of semiconductor material field-effect transistor (FET) structure 101, e.g., in a FinFET. Channel regions 102 (e.g., nanoribbons 120) may be of a semiconductor material (such as silicon, silicon germanium, etc.) and may be doped with impurity dopants, such as p-type (acceptor) dopants and/or n-type (donor) dopants. Channel regions 102 (e.g., nanoribbons 120) may be coupled to source and drain regions (not shown), which may be heavily doped semiconductor material, e.g., epitaxially grown from ends of channel regions 102.

Gate structure 125 has a width W₁ on layer 150 wider than width W₂ on liner 146. Insulator layer 150 is between gate structure 125 and first interconnect level 193. Insulator layer 150 contacts a first side 127 of gate structure 125. (First side 127 of gate structure 125 is the front-side 197 of gate structure 125. Second side 128 of gate structure 125 is the back-side 198 of gate structure 125, opposite first side 127.) First side 127 of gate structure 125 has a width W₁. Second side 128 of gate structure 125 has a width W₂. Width W₁ on front-side 197 of gate structure 125 is greater than width W₂ on back-side 198 of gate structure 125.

IC device 100 includes dielectric structure(s) 141 in contact with each of gate structures 125 and between each pair of adjacent gate structures 125. For example, a dielectric structure 141 is between the gate structure 125 at the center of FIG. 1A and the gate structure 125 to the positive y-direction, and a dielectric structure 141 is between the gate structure 125 at the center of FIG. 1A and the gate structure 125 to the negative y-direction. Structure 141 includes a dielectric liner 146 around a dielectric core 145 between adjacent gate structures 125. Dielectric core 145 includes a dielectric material 140. Dielectric liner 146 is a layer of dielectric material between dielectric core 145 and adjacent gate structures 125. In many embodiments, core 145 includes a low-K dielectric material 140 within (and separated from gate structures 125 by) liner 146. Liner 146 may offer protection to (or from) structures 125 or material 140 of core 145. For example, liner 146 may be a protective liner layer over gate structures 125 (etc.) during back-side, BEOL processing before material 140 is deposited in, on, or over liner 146. In some embodiments, dielectric material 140 includes an oxide and liner 146 includes a nitride. In some such embodiments, the nitride of liner 146 protects gate metal 121 of structure 125 from the oxide of material 140.

Dielectric structure 141 is in contact with insulator layer 150 between gate structures 125. Gate structures 125 are separated by at least a width W₄ at insulator layer 150. Dielectric structure 141 has a width W₄ at insulator layer 150 (e.g., between widths W₁ of adjacent gate structures 125). Width W₃ of dielectric structure 141 is between each back-side 128, 198 of adjacent gate structures 125 (e.g., between widths W₂ of adjacent gate structures 125). Width W₃ (e.g., towards back-side 198 of substrate 199) is greater than width W₄ (e.g., towards front-side 197 of substrate 199).

Layer 150 is between dielectric structure 141 and interconnect level 193 and between structure 141 and dielectric layer 195. In some embodiments (e.g., with liner 146 on a back-side 128, 198 of gate structure 125), as in the example of FIG. 1A, structure 125 is between dielectric structure 141 and insulator layer 150. In some embodiments (e.g., with liner 146 on a back-side 128, 198 of gate structure 125), as in the example of FIG. 1A, dielectric structures 141 are continuous to both sides of gate structure 125 and on a back-side 128, 198 of structure 125. For example, dielectric liners 146 of dielectric structures 141 to both sides of gate structure 125 are continuous, e.g., a single, continuous layer. Dielectric liner 146 is continuous on back-side 128 of gate structure 125 (to the back-side 198 of gate structure 125). First, second, and third portions 147A, 148A, 149A of dielectric liner 146 contact gate structure 125. Portion 147A contacts insulator layer 150 and a first sidewall 123 of gate structure 125. Portion 149A contacts insulator layer 150 and a second sidewall 124 of gate structure 125. Portion 148A is between portions 147A, 149A, and portion 148A contacts back-side 128, 198 of gate structure 125 (e.g., on insulator 122, in some embodiments). In some embodiments (e.g., with a non-zero thickness T₁ of dielectric material 140 on a back-side 128, 198 of structure 125), as in the example of FIG. 1A, a single dielectric structure 141 is characterized to include multiple dielectric cores 145, e.g., the dielectric cores 145 to both sides of gate structure 125, which are continuous on back-side 128, 198 of gate structure 125 (e.g., a continuous structure of dielectric material 140 is continuous from adjacent layer 150 and portion 147A at sidewall 123 to adjacent portion 148A on a back-side 128, 198 of structure 125 to adjacent layer 150 and portion 149A at sidewall 124).

Portion 147A of liner 146 continues to contact sidewall 123 of adjacent gate structure 125 (e.g., contacting opposing or facing sidewalls 123 with a core 145 between sidewalls 123). Portion 147A contacts both sidewalls 123 of adjacent gate structures 125 and insulator layer 150 between opposing or facing sidewalls 123. Portion 149A of liner 146 continues to contact sidewall 124 of adjacent gate structure 125 (e.g., contacting opposing or facing sidewalls 124 with a core 145 between sidewalls 124). Portion 149A contacts both sidewalls 124 of adjacent gate structures 125 and insulator layer 150 between opposing or facing sidewalls 124.

Transistor structure 101 may be a FET, such as a metal-oxide-semiconductor (MOS) FET, and gate insulator 122 may include an oxide, or any other suitable material. Gate insulator 122 may include multiple insulators, e.g., as any number of material layers and with any suitable thickness(es) over channel region 102, between channel region 102 and one or gate metals 121 of structure 125. For example, insulator 122 may include an optional interface layer (e.g., of a native or thermal oxide) over nanoribbons 120, between nanoribbons 120 and a high permittivity ("high-K") material. The oxide may be present only on interfaces with nanoribbons 120. Gate insulator 122 may include a high-K dielectric material with any composition known to be suitable for a transistor gate insulator, e.g., with a bulk relative permittivity greater than 7. Examples include a metal oxide including predominantly hafnium (Hf), predominantly aluminum (Al), predominantly magnesium (Mg), predominantly lanthanum (La), or predominantly zirconium (Zr). In other examples, the high-K material is an alloyed metal oxide including primarily two or more metals (e.g., HfAlO, HfZrO, HfZrLaO). In some further embodiments, the high-K material further includes silicon. For example, metal silicates, such as HfSiO or ZrSiO, may also be suitable a high-K material for insulator 122. Gate insulator 122 may further include dipole dopants, which may be within or on an interface of insulator 122 and may act to shift a threshold voltage of transistor structure 101. Gate insulator 122 is between channel region 102 and a conductive material.

Gate structure 125 is a gate electrode for controlling the conduction of channel regions 102 in transistor structures 101, and structure 125 may include any suitable conductive material, such as one or more gate metals 121. Gate metal(s) 121 may be workfunction metals, e.g., for setting a threshold voltage for each transistor structure 101. Gate structure 125 may include multiple workfunction metals 121, e.g., to set different threshold voltages. Transistor structures 101 may each be either of an n- or p-type MOSFET, and gate workfunction metals 121 may differ accordingly, e.g., to set corresponding threshold voltages. Metals 121 as described herein are conductive materials, but may include nitrides, carbides, etc., of metal elements.

Interconnect metallization levels 193, 194 are in interconnect metallization networks 191, 192 on opposing sides 197, 198 of substrate. As used herein, the term "metallization level" or "interconnect level" describes levels or layers primarily with interconnections or wires that provide electrical routing, generally formed of metal or other electrically conductive material. Adjacent metallization layers may be formed of different materials and by different methods. Metallization and interconnect layers may generally be over a device layer, e.g., having transistor structures 101, including in a stack or network of multiple interconnect layers or levels over a device layer. A device layer may include metallization and other interconnect features, but a device layer may be the layer, or one of the two or few layers, containing the all or the majority of the transistors in an IC die. A device layer may be at or adjacent a base from which both the front- and back-sides are built up (e.g., first in one direction and then the opposite). While transistors are often not deployed in layers meant primarily for interconnections, transistor structures may be deployed in metallization layers over device layers. Adjacent metallization layers or levels 193, 194 within networks 191, 192 are interconnected by vias that may be characterized as part of the metallization layers or between the metallization layers. As shown, in some embodiments, front-side metallization levels 193 within network 191are formed over and immediately adjacent structures 101. The back-side is then the opposite side, which may be exposed during processing by attaching the front-side to a carrier wafer and exposing the back-side (e.g., by back-side grind or etch operations) as known in the art.

In the illustrated example, front-side metallization levels 193 include any number of metallization layers such as eight or more metallization layers. Similarly, back-side metallization levels 194 include any number of metallization layers such as two to five metallization layers or levels. Front-side metallization levels 193 and back-side metallization levels 194 are embedded within dielectric layers 195, 196. Layers 195, 196 advantageously include low-K material(s), which may minimize parasitic capacitances between adjacent metallization levels 193 or 194.

Substrate 199 may include any suitable material or materials. In some examples, substrate 199 may include monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may refer specifically to a base material (for example, a thick base or layer of semiconductor material) that other materials (such as metals and dielectrics) are built up on. In some contexts, substrate 199 may refer to a base material layer and/or any build-up layers, etc., over or under the base or transistor structures 101. In many embodiments, a semiconductor material is absent from substrate 199 under and between source and drain bodies (not shown in FIG. 1A) and under nanoribbons 120 (e.g., in a subfin), for example, having been removed from back-side 198 prior to the fabrication of back-side interconnect network 192. In some embodiments, a semiconductor material is retained in selected regions of substrate 199, e.g., to the back-side 198 of transistor structures 101. Substrate 199 may include other semiconductor materials, metals, dielectrics, dopants, and other materials commonly found in semiconductor substrates.

FIG. 1B illustrates IC device 100 having isolation structures 142 between source or drain regions 110 and metallization structures 130 and between first and second interconnect metallization levels 193, 194. IC device 100 includes metallization levels 193, 194 and transistor structures 101 between interconnect levels 193, 194, including source or drain regions 110. Each transistor structure 101 is coupled to interconnect level 193 by a metallization structure 130 on front-side 117 of a corresponding source or drain region 110. (Front-side 117 of region 110 is the side 117 of region 110 towards the front-side 197 of substrate 199. Back-side 118 of region 110 is the side 118 of region 110 towards the back-side 198 of substrate 199.)

Metallization structures 130 may be contacts, e.g., of any suitably conductive material (metal or not), that couple regions 110 to other structures, such as other regions 110, transistor structures 101, levels 193, etc. Transistor structures 101 and regions 110 are coupled to metallization level 193 in front-side network 191 at least by trench contact vias 153 through insulator layer 195. In some embodiments, some of transistor structures 101 are coupled to interconnect level 194 by a similar metallization structure 132, but on back-side 118 of a corresponding source or drain region 110. Structures 132 and regions 110 are coupled to metallization level 194 in back-side network 192 at least by back-side contact vias 135 through dielectric liner 146, dielectric material 140, and insulator layer 196. Some of vias 135, 153 (for example, contacting back-side structure 132) may be not shown in the viewing plane of FIG. 1B. Some of vias 135, 153 may contact structures 130, 132 in front or behind the viewing plane. Other contacts or vias (not shown, e.g., in front or behind the viewing plane) may couple structures 101 to one or both of levels 193, 194 in networks 191, 192.

IC device 100 includes dielectric structure 142 between adjacent metallization structures 130. Dielectric structure 142 is in contact with insulator layer 195 between interconnect level 193 and metallization structures 130. Dielectric structure 142 includes dielectric core 145 and dielectric liner 146. Dielectric core 145 is in contact with first, second, and third portions 147B, 148B, 149B of dielectric liner 146. Portion 147B of dielectric liner 146 is in contact with a first metallization structure 130, and portion 149B of dielectric liner 146 is in contact with an adjacent second metallization structure 130. Portion 148B of dielectric liner 146 is in contact with insulator layer 195 between (and continuous with) portions 147B, 149B.

Dielectric structure 142 has a narrower front-side width W₆ of than back-side width W₅. Width W₅ of dielectric structure 142 is between back-sides 118 of adjacent source or drain regions 110 (opposite front-sides 117 of regions 110 and front-side 197 of substrate 199). Width W₆ of dielectric structure 142 is adjacent to insulator layer 195. Width W₅ is greater than width W₆.

Another dielectric structure 142 (e.g., having a core 145 within a liner 146) is between an adjacent third source or drain region 110 and the first two source or drain regions 110 and between an adjacent third metallization structure 130 and the first two metallization structures 130. The additional dielectric structure 142 is also between and in contact with adjacent structures 130. In some embodiments, as in the example of FIG. 1B, dielectric liners 146 in both dielectric structures 142 are continuous on back-side 118 of source or drain regions 110 (and to the back-side 198 of regions 110). In some embodiments (e.g., with a non-zero thickness T₂ of dielectric material 140 toward back-side 198), as in the example of FIG. 1B, dielectric cores 145 in both dielectric structures 142 are continuous on back-side 118 of source or drain regions 110 (and to the back-side 198 of regions 110).

In many embodiments, dielectric structures 142 (e.g., between adjacent source or drain regions 110) are continuous with dielectric structures 141 (e.g., between gate structures 125, as described at FIG. 1A). In some embodiments, dielectric structures 142 are continuous with dielectric structures 141 (e.g., of FIG. 1A) on back-side 198 of regions 110 and structures 125 (e.g., with non-zero thicknesses T₁, T₂ on back-side 198). In some embodiments, dielectric structures 141, 142 are continuous between transistor structures 101, e.g., with shared cores 145 between and within a common liner 146 between regions 110 and structures 125 (for example, connecting in the x-directions and having overlapping ranges on the y-axis in FIGS. 1A, 1B).

Source and drain regions 110 may be as described elsewhere herein (e.g., at FIG. 1A), for example, heavily doped semiconductor bodies coupled to channel regions 102 (e.g., epitaxially grown from ends of nanoribbons 120). Regions 110 may be of any suitable material. In many embodiments, regions 110 include silicon and/or germanium. Source and drain regions 110 may include an interface sector 113 in contact with (and included by) adjacent metallization structure 130. Interface sector 113 may be characterized as part of either or both of region 110 and/or structure 130. In some embodiments with regions 110 of silicon or silicon germanium, interface sector 113 includes silicon and one or more metals (e.g., in a silicide).

Source and drain regions 110 may be separated (e.g., isolated) by a dielectric material 109, which may advantageously be a low-K material, e.g., to minimize parasitic capacitances between adjacent regions 110 and/or structures 130, 132, etc.

Material 119 may be a dielectric material 119 present on a back-side 118 of some regions 110. Back-side contact structures 132 may be through material 119, which may be deposited over substrate 199 back-side 198 following a removal, for example, by planarization (e.g., chemical-mechanical polish or planarization, CMP), of a semiconductor or other crystalline (e.g., insulator) material of substrate 199. Insulator material 114 may be a dielectric material between regions 110 and material 119. In many embodiments, material 114 is a spacer dielectric also between regions 110 and adjacent gate structures (such as those shown in FIG. 1A).

FIG. 1C shows IC apparatus or device 100 having isolation structures 143, 144 between source or drain regions 110 and gate structures 125 and between first and second interconnect metallization levels 193, 194. The x-z viewing plane of FIG. 1C illustrates cross-sections of nanoribbons 120, e.g., between regions 110 and between dielectric structures 143, 144 and regions 110. None of source or drain regions 110 visible in the viewing plane of FIG. 1C are contacted on back-side 198. Source or drain regions 110 (and material 119 on regions 110) extend beyond gate metal 121 and structures 125 on back-side 198. Dielectric material has thicknesses T₁, T₂ on back-side 198 under gate structures 125 and regions 110, respectively.

FIG. 1C shows IC device 100 including multiple layers 150. The x-z viewing plane of FIG. 1C illustrates an insulator layer 150 between each pair of adjacent metallization structures 130. Insulator layer 195 is between metallization level 193 and the group of insulator layers 150. Insulator layer 195 is in contact with the insulator layers 150. Some regions 110 are absent between stacks of nanoribbons 120, and dielectric material 140 is between the stacks of nanoribbons 120. Some metallization structures 130 include interface sectors 113 in contact with dielectric liner 146 rather than region 110. Adjacent metallization structures 130 are each separated by a length L extending in the x-direction.

Isolation structure 143 is between adjacent metallization structures 130, in contact with insulator layer 150 and both of the adjacent metallization structures 130. Isolation structure 143 is through (e.g., between and in contact with) nanoribbons 120 to both sides (e.g., in the x-direction). Width W₇ of dielectric structure 143 is between back-sides 118 of adjacent source or drain regions 110. Dielectric structure 143 has a width W₈ at insulator layer 150. Back-side width W₇ is greater than front-side width W₈.

Isolation structure 144 is between back-side interconnect metallization level 194 and metallization structures 130. Isolation structure 144 is between source or drain regions 110 and interconnect level 194. Isolation structure 144 is between adjacent (e.g., collinear or coaxial) stacks of nanoribbons 120. Isolation structure 144 includes dielectric liner 146 on core 145, and liner 146 is in contact with metallization structures 130.

Device 100 advantageously has uniform gate structures 125 and metallization structures 130 on front-side 197, regardless of whether isolation structures 143, 144 are under, between, or through structures 125, 130. In contrast, a typical conventional device with conventional isolation structures under, between, or through structures 125, 130 would have non-uniform contours on some affected structures 125, 130, e.g., due to the early, front-side processing required to, for example, remove regions 110 from front-side 197, between structures 125, or remove material between structures 130 to form an isolation structure through nanoribbons 120.

In some embodiments, dielectric structures 141 (e.g., between gate structures 125, as described at FIG. 1A), structures 142 (e.g., between adjacent source or drain regions 110, as described at FIG. 1B), and structures 143, 144 (e.g., as described at FIG. 1C) are all continuous and may be characterized as a single dielectric structures 141 (or 142, 143, 144) with multiple dielectric cores 145 (e.g., all continuous on a back-side 198 of regions 110 and structures 125, 130, sharing a continuous structure of dielectric material 140 with non-zero thicknesses T₁, T₂ on back-side 198). In some embodiments, dielectric structures 141, 142, 143, 144 are all continuous, e.g., with shared cores 145 between and within a common liner 146 between regions 110 and structures 125, 130 (and contacting layers 150, 195).

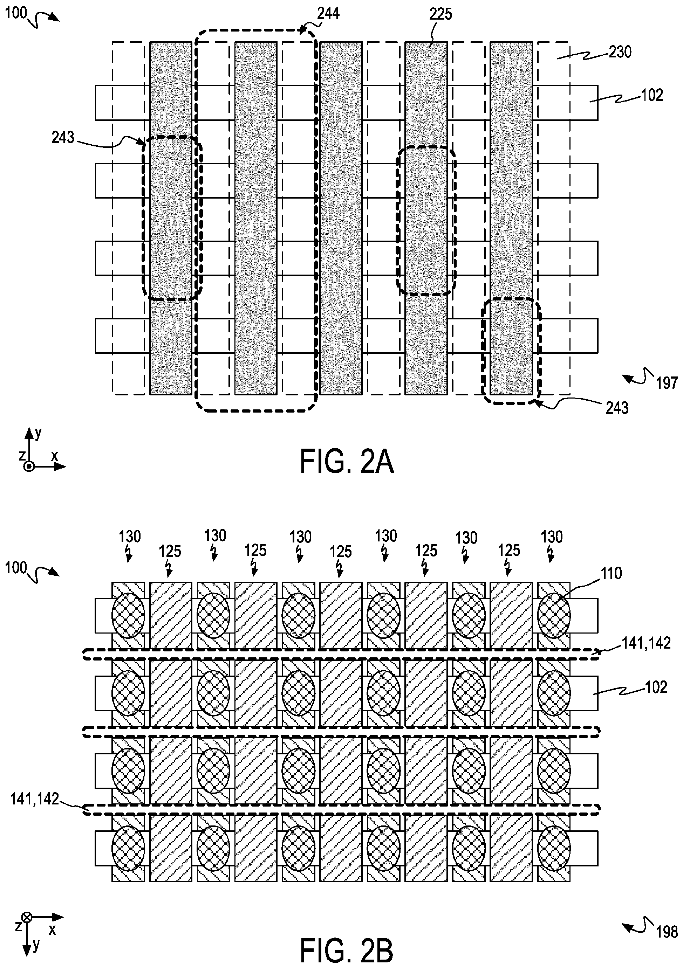

FIGS. 2A and 2B illustrate front- and back-side 197, 198 plan views of an IC device 100 having regular arrays of gate structures 125 and channel regions 102, in accordance with some embodiments. FIG. 2A shows a front-side 197 plan view of workpiece or device 100 with a regular array of gate structures 225 and channel regions 102 (e.g., of nanoribbons or fins), uninterrupted by conventional isolation structures or associated processing and without non-uniform contours caused by conventional, front-side processing to form conventional isolation structures. Gate structures 225 may be final gate structures 225 (e.g., structures 125 of FIG. 1A, etc.) or dummy, sacrificial gate structures 225, e.g., at an intermediate stage of processing. Potential contacts or metallization structures 230 are shown with dashed lines, e.g., for illustrative purposes, such as to not obscure channel regions 102. Large areas 243, 244 are delineated with thick dashed, rounded borders to show example areas of potential improvement in disclosed device 100.

Area 244 is a region that might be severely impacted (e.g., interrupted) by front-side processing in a conventional device to form an isolation structure instead of an improved isolation structure 144 (e.g., as described at FIG. 1C). Portions of channel regions 102 may be removed and non-uniform gate structures 225 may be formed in area 244 in a non-improved device.

Areas 243 are regions that might be severely impacted (e.g., interrupted) by front-side processing in a conventional device to form isolation structures instead of an improved isolation structure 143 (e.g., as described at FIG. 1C). Non-improved isolations may be formed through gate structures 225 is areas 243, which may damage (and/or cause non-uniform contours on) adjacent structures 230.

FIG. 2B illustrates an example back-side 198 plan view of disclosed device 100 with an array of uniform gate and trench-contact structures 125, 130 over channel regions 102. Continuous gate and contact isolation structures 141, 142 are between adjacent gate structures 125 and between adjacent trench-contact structures 130 (for example, connecting in the x-directions and having overlapping ranges on the y-axis). FIG. 2B shows different levels of device 100, rather than a strict cross-section, e.g., for illustrative purposes. Source and drain regions 110 are at intersections of channel regions 102 and contact structures 130. In some embodiments, as in the example of FIG. 2B, device 100 includes no back-side structures 132 contacting regions 110.

Structures 125 can be formed uniformly through front-side and much of back-side processing, and any non-uniform processing (such as coupling individual structures 125 with metallization) may be delayed until later in a process, which may minimize impacts on subsequent processing operations. For example, in some embodiments, a uniform and uninterrupted grid of gate structures 225, trench contact structures 230, etc., is formed on a front side 197 of device 100 (e.g., as shown in FIG. 2A), and selected structures 225, 230 are cut (e.g., etched, separated) from back-side 198, which may reduce non-uniformities and process variation. In some embodiments, a uniform and uninterrupted grid of gate structures 225, trench contact structures 230, etc., is formed on a front side 197 of device 100 (e.g., as shown in FIG. 2A), all structures 225, 230 are cut (e.g., etched, separated) from back-side 198 into a uniform array of structures 225, 230, and selected structures 225, 230 are coupled together (e.g., later still in the process flow), which may minimize or at least further reduce non-uniformities and process variation.

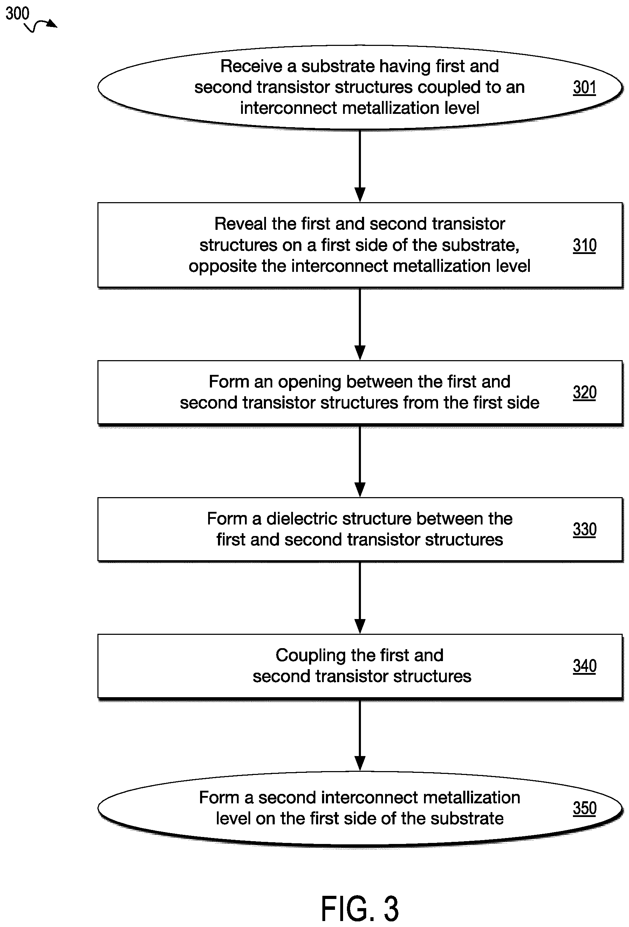

FIG. 3 is a flow chart of methods 300 for forming a dielectric structure between transistor structures from a back-side of a substrate, in accordance with some embodiments. Methods 300 include operations 301-350. Some operations shown in FIG. 3 are optional. Additional operations may be included. FIG. 3 shows an example sequence, but the operations can be done in other orders as well, and some operations may be omitted. Some operations can also be performed multiple times before other operations are performed. For example, multiple openings and dielectric structures may be formed before forming an interconnect level on the back-side of a substrate. Some operations may be included within other operations so that the number of operations illustrated FIG. 3 is not a limitation of the methods 300.

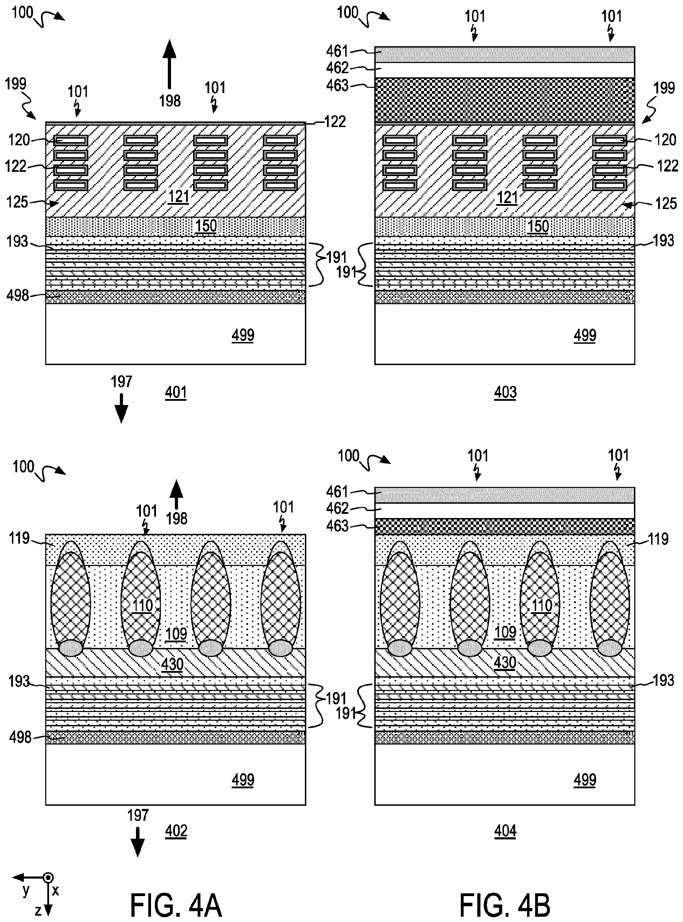

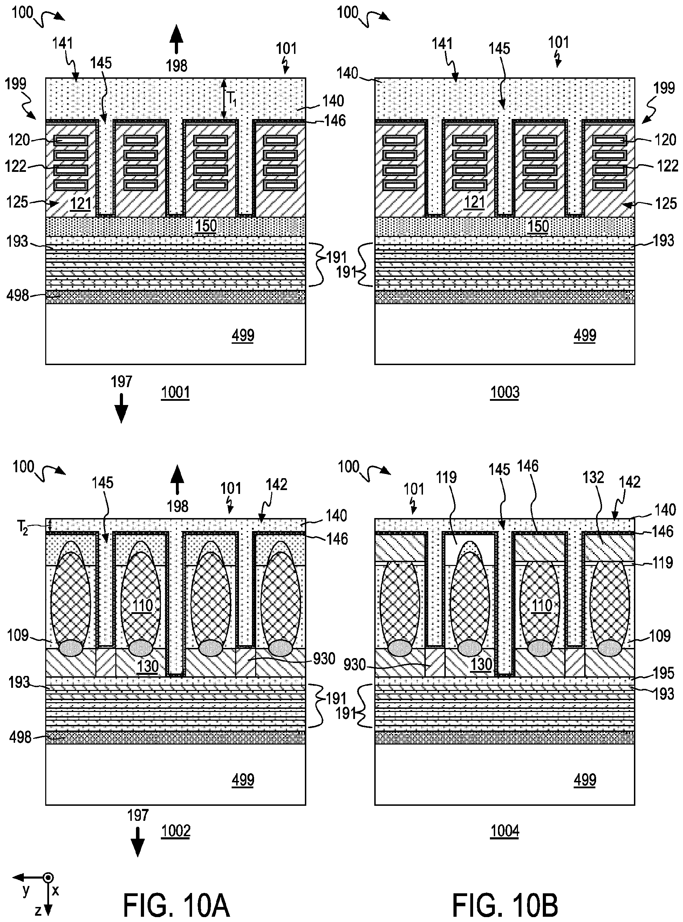

FIGS. 4A, 4B, 5A, 5B, 6A, 6B, 7A, 7B, 8A, 8B, 9A, 9B, 10A, 10B, 11A, 11B, 12A, 12B, 13A, and 13B illustrate cross-sectional profile views of IC device 100 having improved dielectric structures 141, 142 between structures 125, 130, at various stages of manufacture, in accordance with some embodiments. FIGS. 4A-13B show possible examples of intermediate structures during an embodiment of a practice of methods 300 of FIG. 3. Some embodiments are shown without back-side contact structures 132 (e.g., in FIGS. 4A-10A), before other embodiments are shown with back-side contact structures 132 (e.g., in FIGS. 10B-13B), e.g., for illustrative purposes.

Returning to FIG. 3, methods 300 begin at operation 301 with receiving a substrate. In many embodiments, the substrate includes multiple transistor structures (e.g., at least first and second transistor structures), as well as an interconnect metallization level over the transistor structures. The received substrate may be similar to that described elsewhere herein (e.g., at FIG. 1A). Notably, the substrate may include a base material layer (e.g., of a semiconductor or insulator material) on a first side of the substrate, opposite the side of the substrate having the interconnect metallization level over the transistor structures. For example, the transistor structures may be built up over a base layer of a semiconductor, such as silicon, and the transistor structures may be between the base layer on a first side of the substrate and the interconnect metallization level on a second, opposing side of the substrate. Also of note, some constituent structures (such as gate or other metallization structures) of transistor structures that be may distinct or separate as described elsewhere herein (e.g., at least at FIGS. 1A and 1B) may be larger, shared structures as received (for example, before being separated during later processing into smaller, unshared structures). The substrate may be any suitable substrate (such as a die or wafer) and may include any suitable material and structures.

The substrate may be mounted on a carrier substrate, such as a carrier wafer, for further handling during processing. In some embodiments, the substrate may be bonded to a carrier structure, e.g., with a glue or any suitable adhesive or interface layer.

Methods 300 continue with revealing transistor structures on a first side of the substrate (e.g., opposite an interconnect metallization level on an opposing second side) at operation 310. In some embodiments, at least first and second transistor structures are revealed on a first side of the substrate, opposite a second side of the substrate. The substrate may include an interconnect metallization level on the second side, and the first and second transistor structures coupled to the interconnect metallization level. The first side and the transistor structures may be revealed by any suitable means. In many embodiments, a back-side grind removes much of the substrate material on the first (back) side of the substrate. In some embodiments, a planarization, such as a CMP, removes some material, e.g., more closely to the transistor structures and after a back-side grind. In some embodiments, a back-side etch selectively removes one or more material layers nearest the transistor structures. For example, a back-side etch may selectively remove a material layer (e.g., of a semiconductor material) to reveal (e.g., expose) a gate structure and/or source and drain regions. Multiple etches may be employed, e.g., to reveal various structures and surfaces having differing compositions. For example, different back-side etches may sequentially remove different material layers over a gate structure and source and drain regions.

FIG. 4A illustrates cross-sectional views 401, 402 of substrate 199 in a workpiece or IC device 100 having revealed transistor structures 101 on back side 198, in accordance with some embodiments, for example, following a performance of revealing operation 310. Substrate 199 is coupled to carrier substrate 499 by interface layer 498 (which may be a bonding layer). View 401 shows a shared gate structure 125, which is coupled to interconnect level 193. Nanoribbons 120 extend in the x-directions, through gate structure 125 and couple source or drain regions 110. Gate structure 125 is shared by multiple stacks of nanoribbons 120. Layer 150 is between structure 125 and level 193. View 402 illustrates a shared metallization structure 430 coupled to multiple source or drain regions 110, which are offset (e.g., in an x-direction) from and coupled to nanoribbons 120. Metallization structure 430 is shared by multiple source or drain regions 110.

Returning to FIG. 3, methods 300 continue with forming an opening from the first side between the transistor structures at operation 320. In some embodiments, an opening is formed between first and second transistor structures from the first side, opposite the interconnect metallization level. In some such embodiments, the opening is between a first metallization structure in the first transistor structure and a second metallization structure in the second transistor structure. In some such embodiments, the opening has a greater (e.g., wider) width on the first side of the first and second transistor structures than the width on the second side of the first and second transistor structures. For example, the opening may have a taper, narrowing with depth, e.g., with the width at a back-side surface being greater than the width at the etch front on a side of the transistor structures opposite the back side.

The opening may be formed by any suitable means, such as an anisotropic plasma etch selective to an etch-stop layer. The etch may be a cut, such as a metal-gate cut or an etch through trench contacts. In some embodiments, forming the opening between the first and second transistor structures forms the first and second metallization structures by etching through and bisecting a shared metallization structure. In some such embodiments, etching through and bisecting the shared metallization structure stops on an insulator layer between the first and second metallization structures and the interconnect metallization level. In some such embodiments, the first metallization structure couples a first source or drain region to the interconnect metallization level, and the second metallization structure couples a second source or drain region to the interconnect metallization level. In other embodiments, the first metallization structure is a first gate structure, and the second metallization structure is a second gate structure.

FIG. 4B shows cross-sectional views 403, 404 of workpiece or IC device 100 having mask layers 461, 462, 463 on back side 198, in accordance with some embodiments, for example, during a forming of an opening at operation 320. Layers 461, 462, 463 may be deposited over back side 198 to facilitate etching through structure 125 and between structures 130. For example, layer 461 may be a photolithographic mask, e.g., of a photoresist. Layer 462 may be of an anti-reflective coating (ARC) material. Layer 463 may be a hardmask, e.g., a material that provides an etch selectivity with both a photoresist layer 461 and materials to be etched below. Multiple hardmask layers 463 may be deployed, for example, having different etch selectivities.

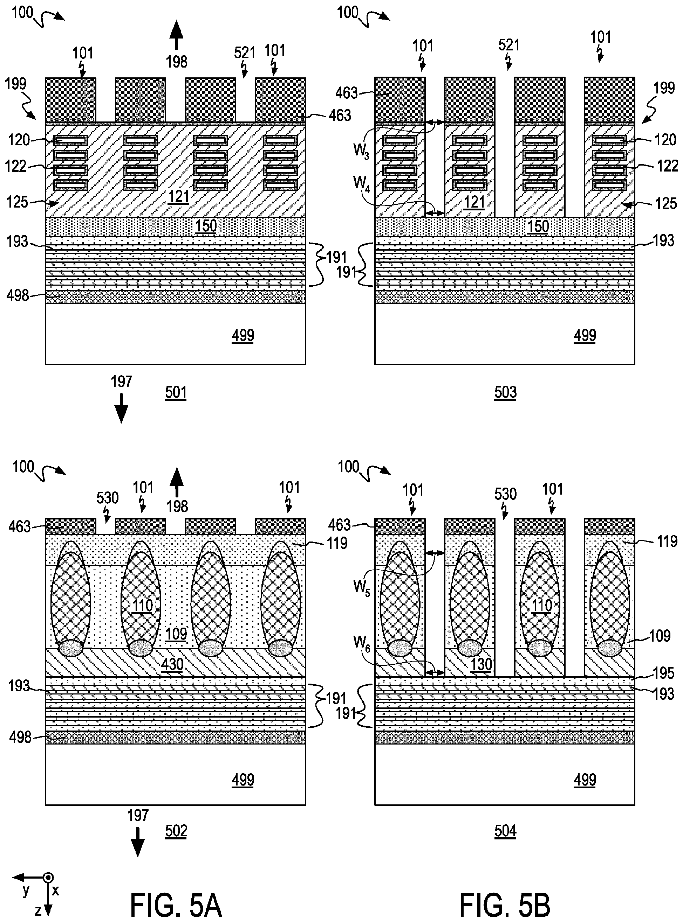

FIG. 5A illustrates cross-sectional views 501, 502 of workpiece or IC device 100 having patterned mask layer 463 with openings 521, 530 on back side 198, in accordance with some embodiments, for example, during a forming of an opening at operation 320. Layer 463 may be a hardmask patterned using, e.g., a photoresist layer 461 (not shown). View 501 shows openings 521 in layer 463 and over gate metal 121. View 502 illustrates openings 530 layer 463 and over metallization structures 130.

FIG. 5B shows cross-sectional views 503, 504 of workpiece or IC device 100 having openings 521, 530 from back side 198, in accordance with some embodiments, for example, during a forming of one or more openings at operation 320. View 503 illustrates openings 521 through and between gate metal 121 and down to layer 150. Openings 521 through gate metal 121 and between gate structures 125 have a first width W₃ at back-side 198 of gate structures 125 greater than a second width W₄ at front-side 197 of gate structures 125. Each stack of nanoribbons 120 is through an unshared gate structure 125 between openings 521. View 504 shows openings 530 through and between metallization structures 130 and down to layer 195. Openings 530 between metallization structures 130 have a first width W₅ at back-side 198 of structures 130 greater than a second width W₆ at front-side 197 of structures 130. Each source or drain region 110 is coupled to an unshared metallization structure 130 between openings 530. Openings 521, 530 may be continuous (for example, connecting in the x-directions and having overlapping ranges on the y-axis).

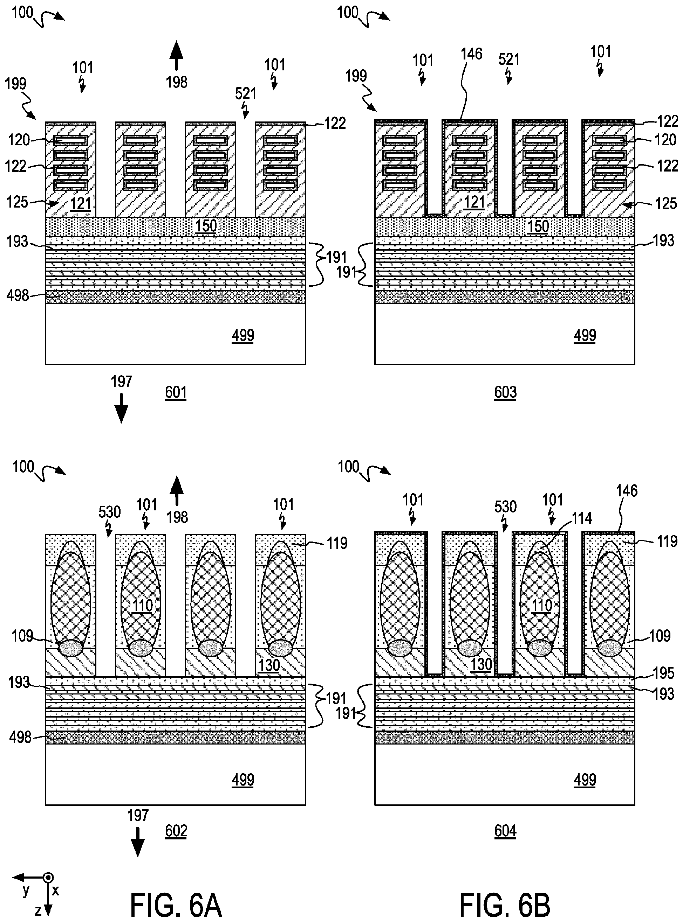

FIG. 6A illustrates cross-sectional views 601, 602 of workpiece or IC device 100 having openings 521, 530 from back side 198 and absent any mask layers, in accordance with some embodiments, for example, following a performance of forming operation 320. View 601 shows openings 521 through and between gate metal 121 and down to layer 150 and back side 198 of substrate 199 exposed (e.g., without any mask layers on substrate 199). View 602 illustrates openings 530 through and between metallization structures 130 and down to layer 195 and back side 198 of substrate 199 exposed (e.g., without any mask layers on substrate 199).

Returning to FIG. 3, methods 300 continue with forming a dielectric structure between the transistor structures at operation 330. In some embodiments, a dielectric structure is formed between the first and second transistor structures. In some such embodiments, the dielectric structure has the same widths as the opening (e.g., formed at operation 320), a greater (e.g., wider) width on the first (e.g., back) side of the first and second transistor structures and a smaller (e.g., narrower) width on the second (e.g., front) side of the first and second transistor structures. In some embodiments, the dielectric structure is formed by depositing a layer of a first dielectric over the first (e.g., back) side of the substrate. In some such embodiments, the layer of the first dielectric is in contact with the first and second transistor structures between the first and second transistor structures. The first dielectric layer may be formed by any suitable means and of any suitable material. In many embodiments, the first dielectric layer is formed conformally by a chemical vapor deposition (CVD), such as an atomic layer deposition (ALD).

In some embodiments, the dielectric structure is formed by depositing a second dielectric over the layer of the first dielectric. For example, the first dielectric layer may be a liner layer conformally lining the opening, and the second dielectric may be deposited into the lined opening, filling the opening and then covering the back side of the substrate. In some such embodiments, the second dielectric is between the first and second transistor structures, the layer of the first dielectric is between the second dielectric and the first transistor structure, and the layer of the first dielectric is between the second dielectric and the second transistor structure. In many embodiments, the second dielectric is deposited by a CVD.

FIG. 6B shows cross-sectional views 603, 604 of workpiece or IC device 100 having liner 146 over back side 198, including in and over openings 521, 530, in accordance with some embodiments, for example, during or following a performance of forming operation 330. View 603 illustrates liner 146 over back side 198, e.g., on metal 121 and insulator 122 of gate structure 125 and on layer 150. View 604 shows liner 146 over back side 198, e.g., on metallization structures 130 and dielectric materials 109, 114 adjacent source or drain regions 110.

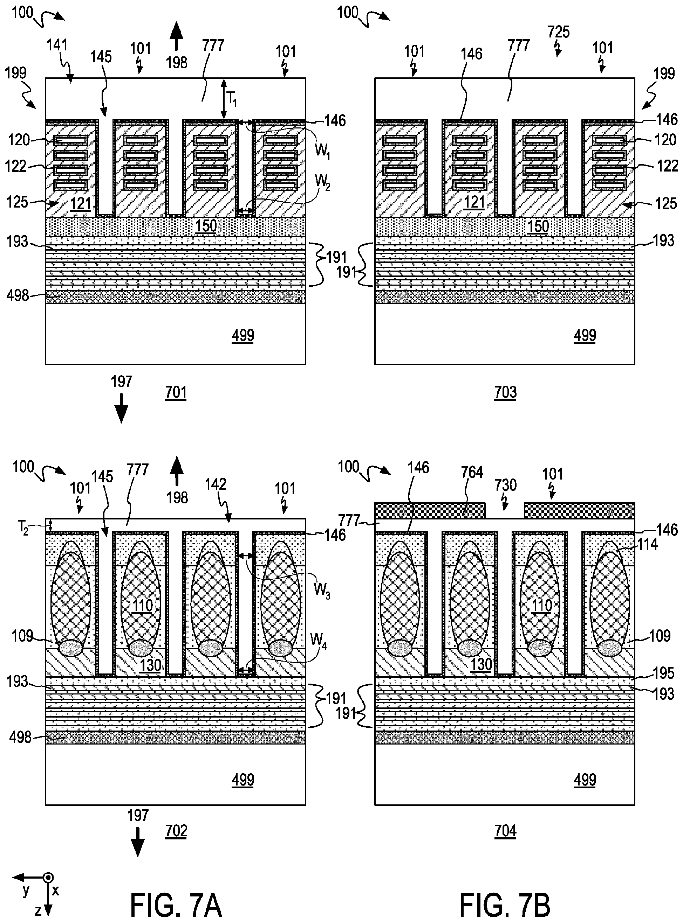

FIG. 7A illustrates cross-sectional views 701, 702 of workpiece or IC device 100 having isolation structures 141, 142 (e.g., with dielectric cores 145 in liner 146) between transistor structures 101 and on back-side 198 of substrate 199, in accordance with some embodiments, for example, following a performance of forming operation 330. Material 777 is a dielectric or mask material 777. In some embodiments, material 777 is a sacrificial or mask material 777 (which may also be a dielectric material) and may enable further processing, e.g., operation 340 of methods 300. In other embodiments, as in the example of FIG. 7A, material 777 is a dielectric material 777 (for example, a dielectric material 140, as described at FIG. 1A) and isolates transistor structures 101. View 701 shows dielectric material 777 in dielectric structure(s) 141 (e.g., in dielectric cores 145 within dielectric liner 146) on back-side 198 and between gate structures 125 of transistor structures 101. Isolation structure(s) 141 between structures 101, 125 have first width W₁ at back-side 198 of structures 101, 125 greater than second width W₂ at front-side 197 of structures 101, 125.

View 702 illustrates dielectric material 777 in dielectric structure(s) 142 (e.g., in dielectric cores 145 within dielectric liner 146) on back-side 198 and between metallization structures 130 of transistor structures 101. Isolation structure(s) 142 between metallization structures 130 have a first width W₃ at back-side 198 of structures 130 greater than a second width W₄ at front-side 197 of structures 130. Isolation structures 141, 142 may be continuous with each other and with other dielectric structures 141, 142, 143, 144 (not shown). For example, in some embodiments, liner 146 and dielectric material 777 are continuous over back-side 198 of substrate 199 over both structures 125, 130 and regions 110. In some embodiments, dielectric structures 141, 142 are continuous between transistor structures 101, e.g., with shared cores 145 of material 777 between and within a common liner 146 between regions 110 and structures 125 (for example, connecting in the x-directions and having overlapping ranges on the y-axis).

Returning to FIG. 3, methods 300 continue with optionally coupling the transistor structures at operation 340. In some embodiments, some transistor structures are coupled, and other transistor structures remain not coupled to other transistor structures. This optional coupling (e.g., following a metal gate cut or trench cut that separated adjacent metallization structures) allows for the uniform fabrication (and other processing) of transistors throughout a larger proportion of a fabrication process before a later coupling that is performed on a smaller subset of transistor structures. The more-uniform fabrication and minimized and delayed processing of selected subsets of devices increases uniformity and reduces process variation.

Coupling transistor structures may involve removal of some dielectric of the isolation structures between transistor structures. In some embodiments, first and second sections of the first and second metallization structures are revealed. In some such embodiments, the first and second sections are revealed by removing a portion of the dielectric structure. The revealed sections of metallization structures may be gate structures (e.g., over channel regions). The revealed sections of metallization structures may be contact structures (e.g., coupling source or drain regions to other source or drain regions or interconnect networks). Multiple and various structures (e.g., gate and/or contact structures) may be revealed concurrently or sequentially. The revealed sections of metallization structures may be at any suitable location (e.g., on a front- or back-side or at any suitable height), and removed portion of the dielectric structure may be at any corresponding location.

Transistor structures may be coupled in openings in or between isolations. In some embodiments, the first and second metallization structures are coupled by depositing a metal on and between the revealed first and second sections of the first and second metallization structures. The metal may be any suitable material and may be deposited by any suitable means. In some embodiments, the metal is conformally deposited on a revealed sidewall section of a metallization structure. In some embodiments, the metal is selectively deposited only on the revealed section of the metallization structure. In some embodiments, the metal is blanket deposited, e.g., over the substrate to a desired thickness or height.

Sacrificial material may be deployed to enable the coupling of selected transistor structures while ensuring that unselected transistor structures are not inadvertently coupled (e.g., shorted together). For example, following removal of a portion of dielectric material from an isolation structure, sacrificial material may be deployed where an electrical connection between gate or contact structures is planned. In some embodiments, the sacrificial material is a hardmask material having etch selectivities with other exposed materials and structures on a substrate backside. Any suitable material(s) may be utilized.

FIG. 7B shows cross-sectional views 703, 704 of workpiece or IC device 100 having a patterned mask layer 764 with openings 725, 730 over a sacrificial or mask material 777, in accordance with some embodiments, for example, during a performance of forming operation 340. Sacrificial material 777 may be deployed where electrical connections are meant to be made, e.g., by coupling adjacent structures 125, 130 with further metallization. View 703 illustrates exposed sacrificial material 777 in opening 725 of mask layer 764. In the example of FIG. 7B, all visible material 777 over gate structures 125 is in opening 725 of mask layer 764, available for removal. In some embodiments, at least some of sacrificial material 777 over gate structures 125 is covered by mask layer 764, e.g., to retain some of sacrificial material 777 for later operations. View 704 shows protected sacrificial material 777 covered by mask layer 764, as well as exposed sacrificial material 777 in openings 730 of mask layer 764. In the example of FIG. 7B, uncovered material 777 is available for removal and covered material 777 is prepared for retention.

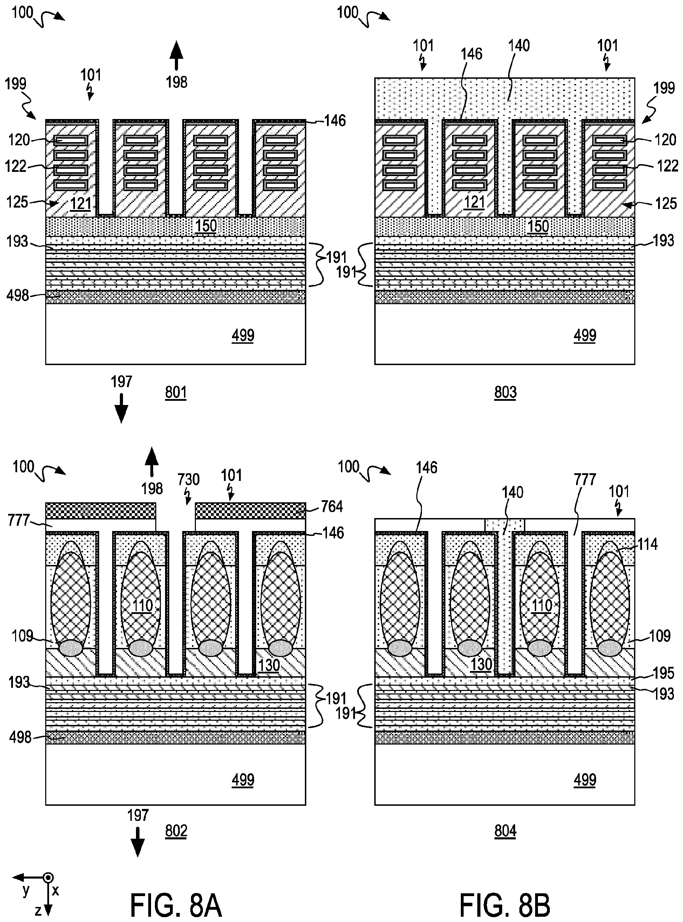

FIG. 8A illustrates cross-sectional views 801, 802 of workpiece or IC device 100 having mask layer 764 covering sacrificial material 777 over dielectric liner 146 and exposed dielectric liner 146 where mask layer 764 is absent, in accordance with some embodiments, for example, during a performance of forming operation 340. Material 777 may be absent wherever not covered by mask layer 764 due to a removal operation. Material 777 may be removed by any suitable means, such as an anisotropic plasma etch selective to an etch-stop layer. Material 777 may be removed concurrently from between structures 125, 130, e.g., by use of an etch selective to liner 146. View 801 shows dielectric material 777 absent and dielectric liner 146 exposed on back-side 198. View 802 illustrates dielectric material 777 retained under mask layer 764 and dielectric liner 146 exposed (and material 777 absent) where mask layer 764 is absent on back-side 198, e.g., at opening 730.

FIG. 8B shows cross-sectional views 803, 804 of workpiece or IC device 100 having dielectric material 140 and exposed sacrificial material 777 on back-side 198, over dielectric liner 146, in accordance with some embodiments, for example, during a performance of forming operation 340. Mask layer 764 is absent. View 803 illustrates dielectric material 140 over dielectric liner 146 and between gate structures 125. View 804 shows dielectric material 140 and exposed sacrificial material 777 (not covered by mask layer 764, which is absent), over dielectric liner 146. Sacrificial material 777 is prepared for removal. In some embodiments, materials 140, 777 are planarized to a same level surface on back-side 198, e.g., over structures 125 and regions 110.

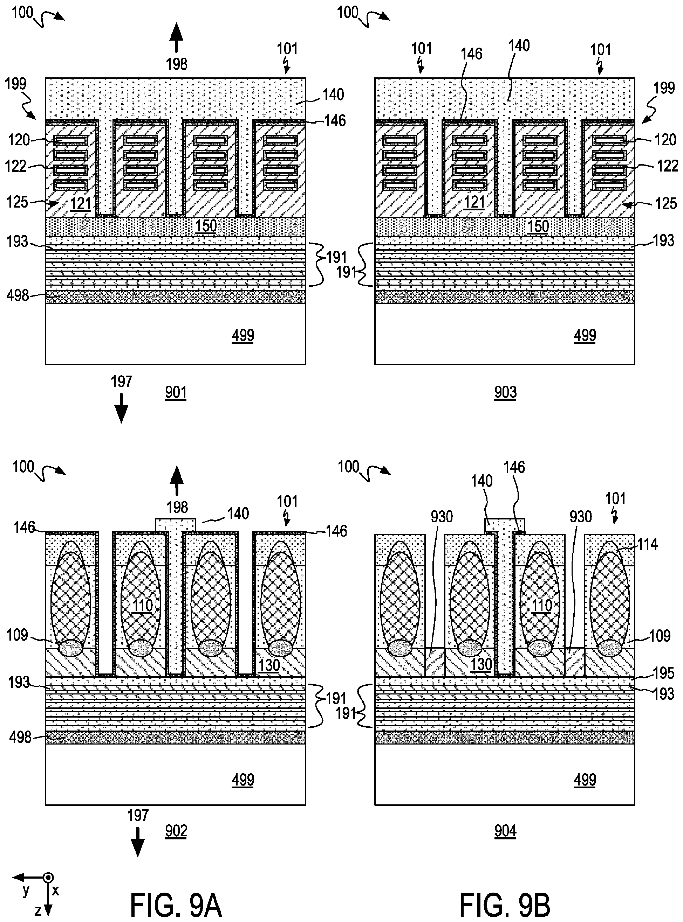

FIG. 9A illustrates cross-sectional views 901, 902 of workpiece or IC device 100 having exposed dielectric liner 146 and dielectric material 140 over liner 146 on back-side 198, in accordance with some embodiments, for example, during a performance of forming operation 340. Sacrificial material 777 is absent. View 901 shows dielectric material 140 over dielectric liner 146, both retained on back-side 198, e.g., following a removal of material 777. View 902 illustrates sacrificial material 777 absent and dielectric liner 146 exposed on back-side 198, e.g., following a removal of material 777. Dielectric material 140 is retained covering portions of dielectric liner 146, e.g., adjacent exposed liner 146 where material 777 was removed.

FIG. 9B shows cross-sectional views 903, 904 of workpiece or IC device 100 having some adjacent metallization structures 130 coupled by metallization structures 930, in accordance with some embodiments, for example, during a performance of forming operation 340. View 903 illustrates dielectric material 140 over dielectric liner 146, both undisturbed on back-side 198 and covering gate metal 121 of structures 125. View 904 shows retained dielectric material 140 over dielectric liner 146 and exposed dielectric materials 109, 114, 140, e.g., following a removal of all unmasked dielectric liner 146. Liner 146 may be removed by any suitable means, e.g., an anisotropic, selective etch of liner 146. Metallization structures 930 couple some adjacent metallization structures 130, e.g., following a selective growth over metallization structures 130 exposed by a removal of liner 146. Metallization structures 930 may be grown by the selective deposition of metal on exposed metal surfaces, e.g., those surfaces not covered by non-growth materials, such as dielectric materials 109, 114, 140.

FIG. 10A illustrates cross-sectional views 1001, 1002 of workpiece or IC device 100 having metallization structures 930 linking transistor structures 101 at front-side 197 of structures 101, in accordance with some embodiments, for example, following a performance of forming operation 330. Isolation structures 141, 142 with dielectric cores 145 of dielectric material 140 in liner 146 are between structures 101, 125, 130 and on back-side 198 of substrate 199. View 1001 shows dielectric material 140 in dielectric structure(s) 141 between gate structures 125. View 1002 illustrates metallization structures 930 coupled to some metallization structures 130 and linking transistor structures 101. Dielectric material 140 is over metallization structures 930 between metallization structures 130. Dielectric material 140 is in dielectric structure 142 between metallization structures 130. Isolation structures 141, 142 may be continuous with each other and with other dielectric structures 141, 142, 143, 144 (not shown). In some embodiments, liner 146 is deposited over dielectric materials (e.g., materials 140 and liner 146) already present (e.g., as shown in FIG. 9B). In some embodiments, liner 146 is deposited after dielectric materials (e.g., materials 140 and liner 146) already present are stripped away.

FIG. 10B shows cross-sectional views 1003, 1004 of workpiece or IC device 100 having metallization structures 930 linking transistor structures 101 at front-side 197 of structures 101 and metallization structures 132 at back-side 198 of structures 101, in accordance with some embodiments, for example, during a performance of forming operation 340. The example of FIG. 10B is much like the example of FIG. 10A. Notably, FIGS. 10B-13B show embodiments including metallization contacts 132 and material 119 on back side 198, e.g., for illustrative purposes. View 1003 illustrates dielectric material 140 in dielectric structure(s) 141 between gate structures 125. Dielectric material 140 has a greater thickness in FIG. 10B than FIG. 10A, e.g., due to the additional back-side features shown in view 1002. View 1004 shows some source or drain regions 110 contacted on back-side 198 by metallization structures 132. Metallization structures 930 are coupled between some metallization structures 130, linking transistor structures 101. Dielectric material 140 is over metallization structures 930 between metallization structures 130. Dielectric material 140 is in dielectric structure 142 between metallization structures 130. Isolation structures 141, 142 may be continuous with each other and with other dielectric structures 141, 142, 143, 144 (not shown).

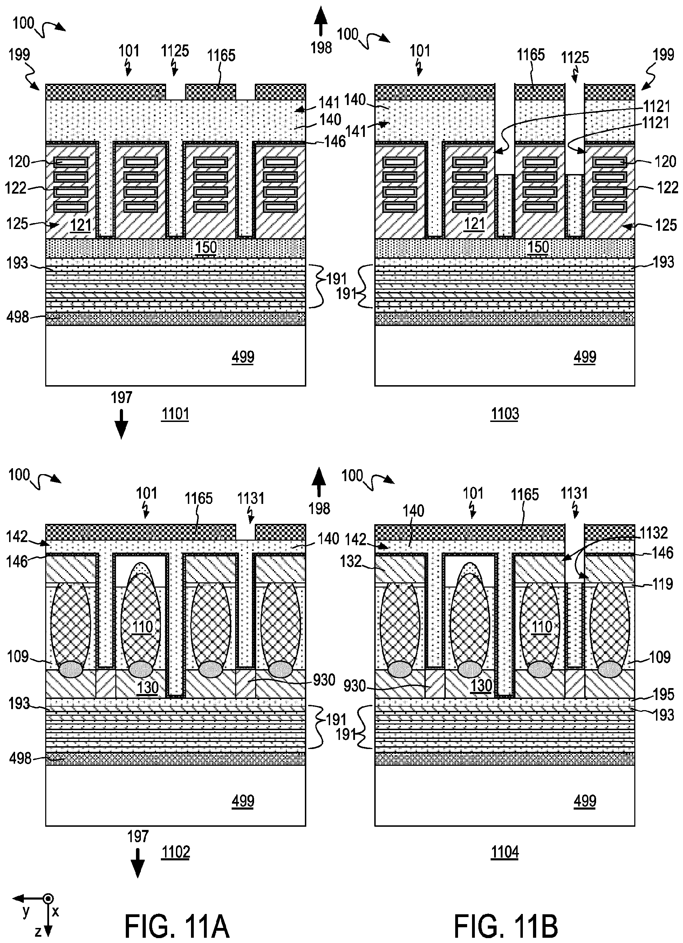

FIG. 11A illustrates cross-sectional views 1101, 1102 of workpiece or IC device 100 having patterned mask layer 1165 with openings 1125, 1131 on back side 198, in accordance with some embodiments, for example, during a performance of forming operation 340. View 1101 shows patterned mask layer 1165 with openings 1125 over dielectric material 140 and gate structures 125. View 1102 illustrates patterned mask layer 1165 with openings 1131 over regions 110 and structures 130, 132, 930.

FIG. 11B shows cross-sectional views 1103, 1104 of workpiece or IC device 100 having revealed sections 1121, 1132 of structures 125, 132 and portions of dielectric material 140 removed, in accordance with some embodiments, for example, during a performance of forming operation 340. Openings 1125, 1131 are through patterned mask layer 1165 extending into and through dielectric material 140 and liner 146 on back side 198 and between structures 125, 132. View 1103 illustrates openings 1125 in material 140 and liner 146 (and so portions of dielectric structure(s) 141 are removed), which reveal sections 1121 of gate metal 121 and structures 125. View 1104 shows openings 1131 in material 140 and liner 146 (and so portions of dielectric structure 142 are removed, which reveal sections 1132 of metallization structures 132.

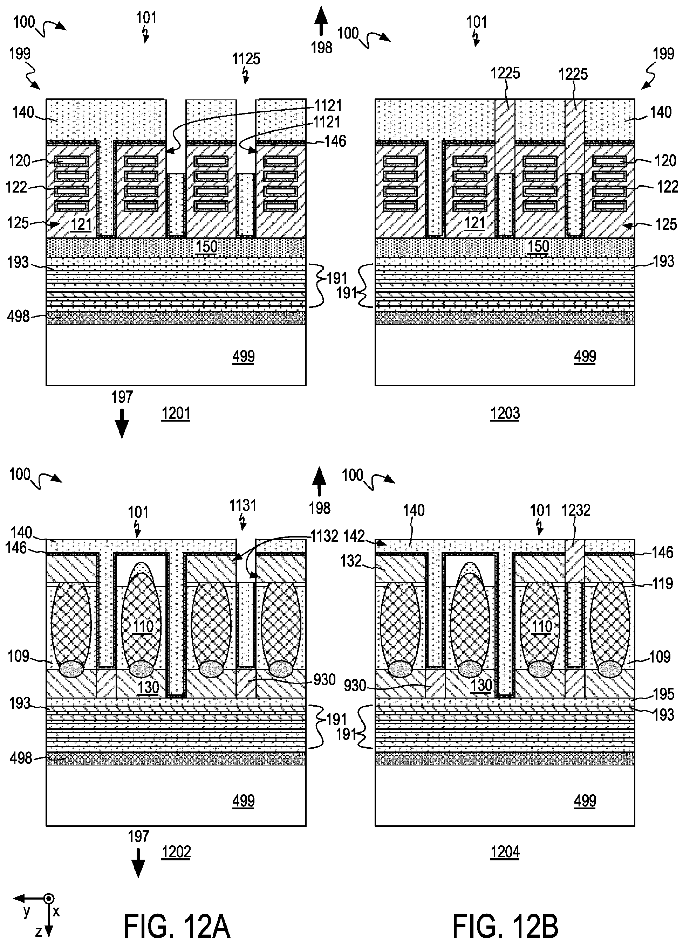

FIG. 12A illustrates cross-sectional views 1201, 1202 of workpiece or IC device 100 having revealed sections 1121, 1132 of structures 125, 132 and patterned mask layer 1165 absent over dielectric material 140, in accordance with some embodiments, for example, during a performance of forming operation 340. View 1201 shows openings 1125 in material 140 and liner 146 and revealed sections 1121 of gate metal 121 and structures 125. View 1202 illustrates openings 1131 in material 140 and liner 146 and revealed sections 1132 of metallization structures 132.

FIG. 12B shows cross-sectional views 1203, 1204 of workpiece or IC device 100 having some adjacent structures 125, 132 coupled by metallization structures 1225, 1232, in accordance with some embodiments, for example, during a performance of forming operation 340. View 1203 illustrates metallization structures 1225 coupling selected gate structures 125 at previously revealed sections 1121 of gate metal 121. View 1204 shows metallization structure 1232 coupling selected metallization structures 132 at previously revealed sections 1132.

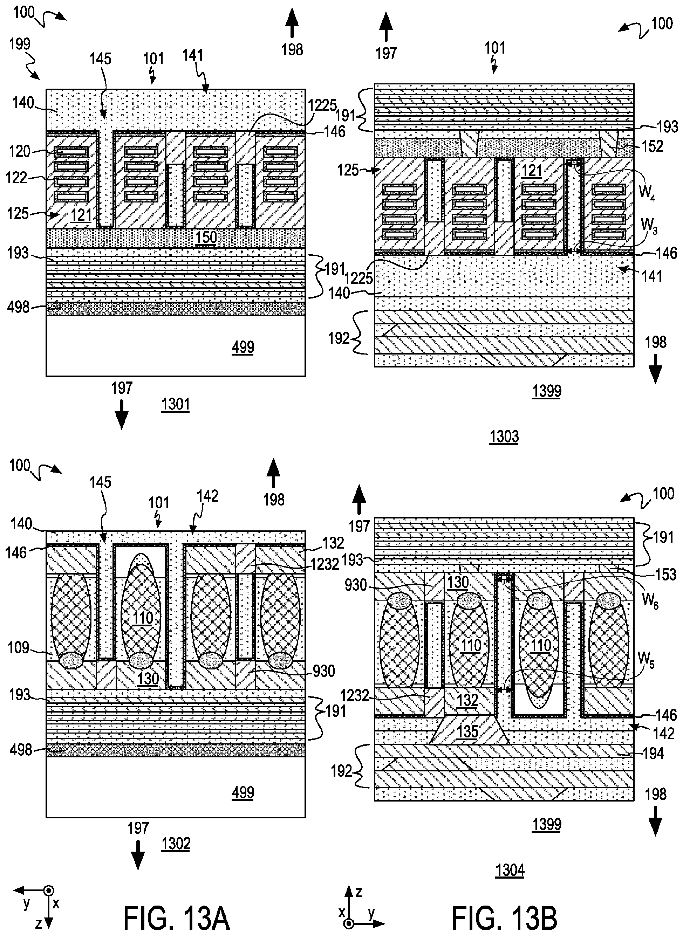

FIG. 13A illustrates cross-sectional views 1301, 1302 of workpiece or IC device 100 having some adjacent structures 125, 132 coupled by metallization structures 1225, 1232 and dielectric structures 141, 142 between other structures 125, 132, in accordance with some embodiments, for example, following operations 330, 340. View 1301 shows metallization structures 1225 through material 140 and contacting sections 1121 of gate metal 121 and coupling some adjacent structures 125. Dielectric structure 141 provides isolation between some structures 125. In some embodiments, liner 146 is deposited over metallization structures 1225, and dielectric material 140 is deposited over liner 146. View 1302 illustrates metallization structures 1232 through material 140 and contacting sections 1132 of metallization structures 132 and coupling some adjacent structures 132. In some embodiments, liner 146 is deposited over metallization structures 1225, and dielectric material 140 is deposited over liner 146.

Returning to FIG. 3, methods 300 continue with optionally forming a second interconnect metallization level on the first side of the substrate at operation 350. The second interconnect metallization level is formed on the first side, opposite the second side and the first interconnect metallization level on the second side. The second interconnect metallization level formed on the first side may be built up over the first and second transistor structures, e.g., with the first and second transistor structures between the first and second interconnect metallization levels. The first and second transistor structures may be in a device layer between and coupled to first and second interconnect metallization levels and networks on opposing sides of the substrate. In many embodiments, the second interconnect metallization level and network have larger conductors (e.g., wider, thicker conductors) than the first interconnect metallization level and network, e.g., for delivering larger current loads. In many embodiments, the second interconnect metallization level and network are coupled with the first interconnect metallization level and network. In some embodiments, the second interconnect metallization level and network couples the IC device to a host component (such as a package substrate, etc.) and to a power supply through the host component. In many embodiments, the second interconnect metallization level and network are coupled with the first and second transistor structures.

FIG. 13B shows cross-sectional views 1303, 1304 of IC device 100 having transistor structures 101 coupled with and between interconnect metallization levels 193, 194 and networks 191, 192 by vias 135, 152, 153, in accordance with some embodiments. Carrier substrate 499 is absent on back-side 198. Second interconnect metallization level 194 and second interconnect network 192 are on back-side 198. Some transistor structures 101 are isolated by dielectric structures 141, 142. Some structures 125, 130, 132 are coupled through isolation structures 141, 142 by metallization structures 930, 1225, 1232.

View 1303 illustrates gate structures 125 coupled with front-side interconnect metallization level 193 and network 191 by vias 152. Some gate metals 121 of gate structure 125 are coupled by metallization structures 1225. Some gate structures 125 and transistor structures 101 are isolated by dielectric structure 141 on back-side 198 and between structures 101, 125. Dielectric structure 141 has a back-side width W₃ greater than a front-side width W₄.

View 1304 shows structures 101, 130 coupled with front-side interconnect metallization level 193 and network 191 by vias 153. Structures 101, 132 are coupled with back-side interconnect metallization level 194 and network 192 by via 135. Some metallization structures 130 are coupled by metallization structures 930. Some metallization structures 132 are coupled by metallization structures 1232. Some source and drain regions 110 and structures 101, 130 are isolated by dielectric structure 142 on back-side 198 and between structures 101, 130 and regions 110. Dielectric structure 142 has a back-side width W₅ greater than a front-side width W₆.

Device 100 is coupled with host component 1399 by back-side interconnect metallization level 194 and interconnect network 192. Host component 1399 is a planar platform and may include dielectric and metallization structures. Host component 1399 may mechanically support, and electrically couple to, IC device 100. At least one side of host component 1399 includes interconnect interfaces, e.g., for soldering or direct bonding to one or more IC devices 100. The opposite side of host component 1399 may include similar interfaces or, e.g., copper pads for socketing or solder bumps for bonding to another host component, for example, a printed circuit board. Host component 1399 may be any platform with interconnect interfaces, such as a package substrate or interposer, another IC device, etc. Host component 1399 may itself be a die or an insulating substrate. Host component 1399 may bond to any platform, such as a package substrate or interposer, another IC device, etc.

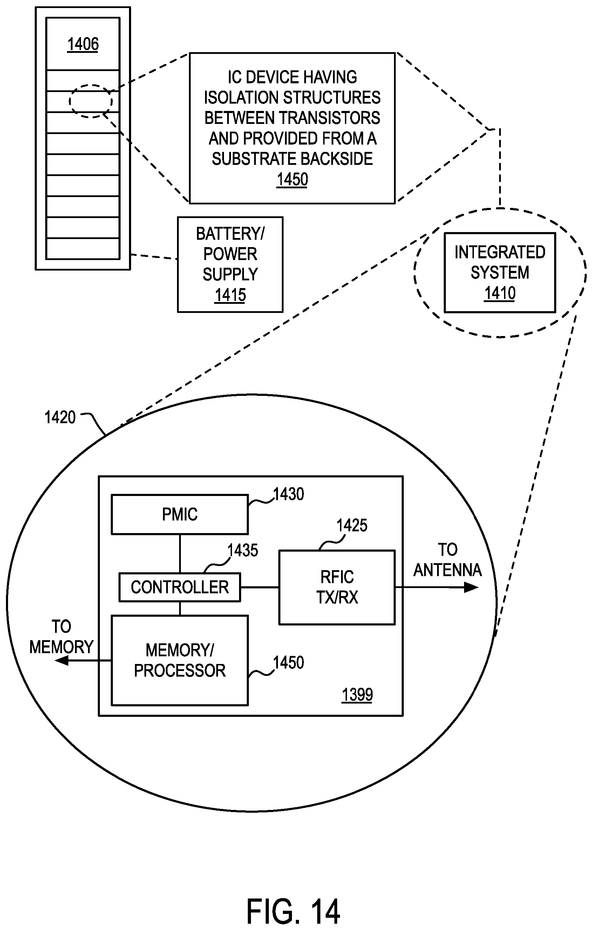

FIG. 14 illustrates a diagram of an example data server machine 1406 employing an IC device having isolation structures formed from a back side of a substrate, in accordance with some embodiments. Server machine 1406 may be any commercial server, for example, including any number of high-performance computing platforms disposed within a rack and networked together for electronic data processing, which in the exemplary embodiment includes one or more devices 1450 having back-side isolation structures.

Also as shown, server machine 1406 includes a battery and/or power supply 1415 to provide power to devices 1450, and to provide, in some embodiments, power delivery functions such as power regulation. Devices 1450 may be deployed as part of a package-level integrated system 1410. Integrated system 1410 is further illustrated in the expanded view 1420. In the exemplary embodiment, devices 1450 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 1450 is a microprocessor including a static RAM (SRAM) cache memory. As shown, device 1450 may be an IC device having isolation structures formed from a back side of a substrate, as discussed herein. Device 1450 may be further coupled to (e.g., communicatively coupled to) a board, an interposer, a substrate, or other host component 1399 along with, one or more of a power management IC (PMIC) 1430, RF (wireless) IC (RFIC) 1425 including a wideband RF (wireless) transmitter and/or receiver (TX/RX) (e.g., including a digital baseband and an analog front end module further includes a power amplifier on a transmit path and a low noise amplifier on a receive path), and a controller 1435 thereof. In some embodiments, RFIC 1425, PMIC 1430, controller 1435, and device 1450 include having isolation structures formed from a back side of a substrate.

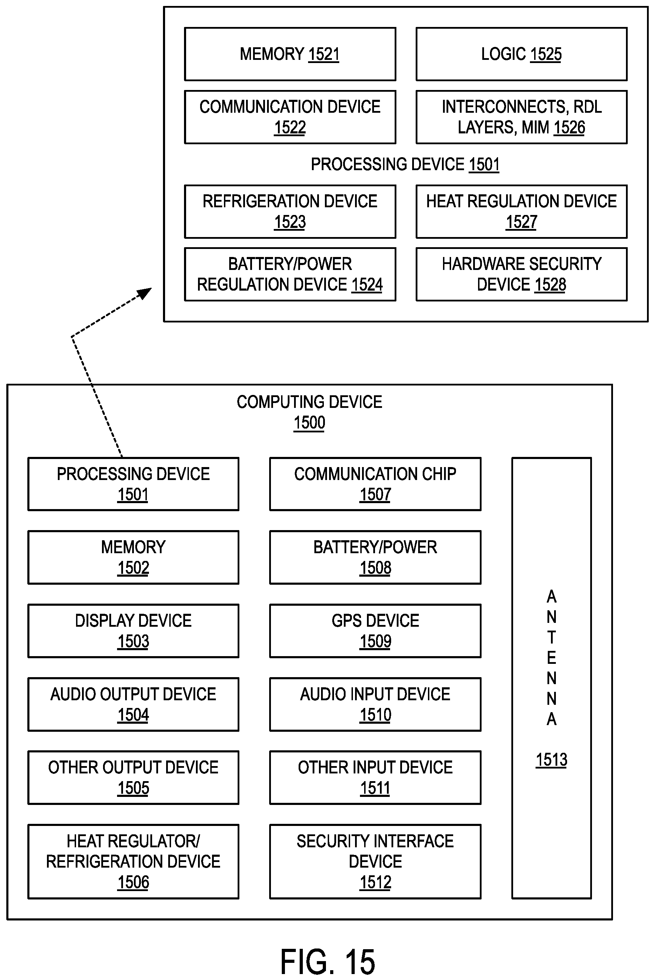

FIG. 15 is a block diagram of an example computing device 1500, in accordance with some embodiments. For example, one or more components of computing device 1500 may include any of the devices or structures discussed herein. A number of components are illustrated in FIG. 15 as being included in computing device 1500, but any one or more of these components may be omitted or duplicated, as suitable for the application. In some embodiments, some or all of the components included in computing device 1500 may be attached to one or more printed circuit boards (e.g., a motherboard). In some embodiments, various ones of these components may be fabricated onto a single system-on-a-chip (SoC) die. Additionally, in various embodiments, computing device 1500 may not include one or more of the components illustrated in FIG. 15, but computing device 1500 may include interface circuitry for coupling to the one or more components. For example, computing device 1500 may not include a display device 1503, but may include display device interface circuitry (e.g., a connector and driver circuitry) to which display device 1503 may be coupled. In another set of examples, computing device 1500 may not include an audio output device 1504, other output device 1505, global positioning system (GPS) device 1509, audio input device 1510, or other input device 1511, but may include audio output device interface circuitry, other output device interface circuitry, GPS device interface circuitry, audio input device interface circuitry, audio input device interface circuitry, to which audio output device 1504, other output device 1505, GPS device 1509, audio input device 1510, or other input device 1511 may be coupled.

Computing device 1500 may include a processing device 1501 (e.g., one or more processing devices). As used herein, the term "processing device" or "processor" indicates a device that processes electronic data from registers and/or memory to transform that electronic data into other electronic data that may be stored in registers and/or memory. Processing device 1501 may include a memory 1521, a communication device 1522, a refrigeration device 1523, a battery/power regulation device 1524, logic 1525, interconnects 1526 (i.e., optionally including redistribution layers (RDL) or metal-insulator-metal (MIM) devices), a heat regulation device 1527, and a hardware security device 1528.

Processing device 1501 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 1500 may include a memory 1502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1502 includes memory that shares a die with processing device 1501. This memory may be used as cache memory and may include embedded dynamic random-access memory (eDRAM) or spin transfer torque magnetic random-access memory (STT-MRAM).

Computing device 1500 may include a heat regulation/refrigeration device 1506. Heat regulation/refrigeration device 1506 may maintain processing device 1501 (and/or other components of computing device 1500) at a predetermined low temperature during operation.

In some embodiments, computing device 1500 may include a communication chip 1507 (e.g., one or more communication chips). For example, the communication chip 1507 may be configured for managing wireless communications for the transfer of data to and from computing device 1500. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 1507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1507 may operate in accordance with other wireless protocols in other embodiments. Computing device 1500 may include an antenna 1513 to facilitate wireless communications and/or to receive other wireless communications (such as AM or FM radio transmissions).

In some embodiments, communication chip 1507 may manage wired communications, such as electrical, optical, or any other suitable communication protocols (e.g., the Ethernet). As noted above, communication chip 1507 may include multiple communication chips. For instance, a first communication chip 1507 may be dedicated to shorter-range wireless communications such as Wi-Fi or Bluetooth, and a second communication chip 1507 may be dedicated to longer-range wireless communications such as GPS, EDGE, GPRS, CDMA, WiMAX, LTE, EV-DO, or others. In some embodiments, a first communication chip 1507 may be dedicated to wireless communications, and a second communication chip 1507 may be dedicated to wired communications.

Computing device 1500 may include battery/power circuitry 1508. Battery/power circuitry 1508 may include one or more energy storage devices (e.g., batteries or capacitors) and/or circuitry for coupling components of computing device 1500 to an energy source separate from computing device 1500 (e.g., AC line power).

Computing device 1500 may include a display device 1503 (or corresponding interface circuitry, as discussed above). Display device 1503 may include any visual indicators, such as a heads-up display, a computer monitor, a projector, a touchscreen display, a liquid crystal display (LCD), a light-emitting diode display, or a flat panel display, for example.

Computing device 1500 may include an audio output device 1504 (or corresponding interface circuitry, as discussed above). Audio output device 1504 may include any device that generates an audible indicator, such as speakers, headsets, or earbuds, for example.

Computing device 1500 may include an audio input device 1510 (or corresponding interface circuitry, as discussed above). Audio input device 1510 may include any device that generates a signal representative of a sound, such as microphones, microphone arrays, or digital instruments (e.g., instruments having a musical instrument digital interface (MIDI) output).

Computing device 1500 may include a GPS device 1509 (or corresponding interface circuitry, as discussed above). GPS device 1509 may be in communication with a satellite-based system and may receive a location of computing device 1500, as known in the art.

Computing device 1500 may include other output device 1505 (or corresponding interface circuitry, as discussed above). Examples of the other output device 1505 may include an audio codec, a video codec, a printer, a wired or wireless transmitter for providing information to other devices, or an additional storage device.

Computing device 1500 may include other input device 1511 (or corresponding interface circuitry, as discussed above). Examples of the other input device 1511 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1500 may include a security interface device 1512. Security interface device 1512 may include any device that provides security measures for computing device 1500 such as intrusion detection, biometric validation, security encode or decode, access list management, malware detection, or spyware detection.

Computing device 1500, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-15. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes first and second interconnect metallization levels on opposing first and second sides of a substrate, first and second transistor structures between the first and second interconnect metallization levels, wherein the first transistor structure is coupled to the first interconnect metallization level by a first metallization structure on the first side of a first source or drain region, and the second transistor structure is coupled to the first interconnect metallization level by a second metallization structure on the first side of a second source or drain region, and a dielectric structure, wherein the dielectric structure is between the first and second metallization structures, the dielectric structure is in contact with an insulator layer between the first interconnect metallization level and the first and second metallization structures, and a first width of the dielectric structure between a second side, opposite the first side, of the first source or drain region and the second side, opposite the first side, of the second source or drain region is greater than a second width of the dielectric structure adjacent to the insulator layer.

In one or more second embodiments, further to the first embodiments, the dielectric structure includes a dielectric core and a dielectric liner, the dielectric core is in contact with first, second, and third portions of the dielectric liner, the first portion of the dielectric liner is in contact with the first metallization structure, the second portion of the dielectric liner is in contact with the insulator layer, and the third portion of the dielectric liner is in contact with the second metallization structure.

In one or more third embodiments, further to the first or second embodiments, the dielectric structure is a first dielectric structure, including a first dielectric liner and a first dielectric core, the apparatus also includes a second dielectric structure, including a second dielectric core and a second dielectric liner, the apparatus also includes a third source or drain region in a third transistor structure and coupled to the first interconnect metallization level by a third metallization structure on the first side of the third source or drain region, the second dielectric structure is between the first and third source or drain regions and in contact with the first and third metallization structures, the first and second dielectric liners are continuous on the second side of the first source or drain region, and the first and second dielectric cores are continuous on the second side of the first source or drain region.

In one or more fourth embodiments, further to the first through third embodiments, the dielectric structure is a first dielectric structure, the insulator layer is a first insulator layer, the first insulator layer is between a second insulator layer and the first interconnect metallization level, the apparatus also includes a second dielectric structure between and in contact with first and second gate structures, the second insulator layer is between the second dielectric structure and the first interconnect metallization level, the second dielectric structure is in contact with the second insulator layer, and a third width of the second dielectric structure is between the second side of the first gate structure and the second side of the second gate structure and is greater than a fourth width of the second dielectric structure at the second insulator layer.

In one or more fifth embodiments, further to the first through fourth embodiments, the first dielectric structure includes a first dielectric liner and a first dielectric core, the second dielectric structure includes a second dielectric liner and a second dielectric core, and the first and second dielectric cores are continuous on the second side of the first gate structure, and the first and second dielectric liners are continuous on the second side of the first gate structure.

In one or more sixth embodiments, further to the first through fifth embodiments, the dielectric structure is a first dielectric structure, the insulator layer is a first insulator layer, the first insulator layer is between a second insulator layer and the first interconnect metallization level, the second insulator layer is between third and fourth metallization structures, the third metallization structure on the first side of a third source or drain region, the fourth metallization structure on the first side of a fourth source or drain region, the apparatus also includes a second dielectric structure between the third and fourth metallization structures and in contact with the second insulator layer and the third and fourth metallization structures, and a third width of the second dielectric structure is between the second side of the third source or drain region and the second side of the fourth source or drain region and is greater than a fourth width of the second dielectric structure at the second insulator layer.

In one or more seventh embodiments, further to the first through sixth embodiments, also including third, fourth, fifth, and sixth metallization structures and third and fourth source or drain regions, wherein the third and fourth, fourth and fifth, and fifth and sixth metallization structures are each separated by a length extending in a direction, the third metallization structure is on the third source or drain region, the sixth metallization structure is on the fourth source or drain region, the dielectric structure is a first dielectric structure, the insulator layer is a first insulator layer, the first insulator layer is between the first interconnect metallization level and a plurality of second insulator layers, the second insulator layers in contact with the first insulator layer, the second insulator layers are between the third and fourth, fourth and fifth, and fifth and sixth metallization structures, and a second dielectric structure is between the second interconnect metallization level and the third and fourth source or drain regions, the second dielectric structure including a dielectric liner on a dielectric core, the dielectric liner in contact with the fourth and fifth metallization structures.

In one or more eighth embodiments, an apparatus includes first and second interconnect metallization levels on opposing first and second sides of a substrate, a gate structure between the first and second interconnect metallization levels, wherein an insulator layer between the gate structure and the first interconnect metallization level contacts a first side of the gate structure having a first width, wherein the first width is greater than a second width of the gate structure on a second side of the gate structure, opposite the first side, and a dielectric structure including a dielectric layer, wherein the gate structure is between the dielectric structure and the insulator layer, first and second portions of the dielectric layer contact the gate structure, a third portion of the dielectric layer is between the first and second portions, the first portion contacts the insulator layer and a first sidewall of the gate structure, and the second portion contacts the insulator layer and a second sidewall of the gate structure.

In one or more ninth embodiments, further to the eighth embodiments, the gate structure is a first gate structure between second and third gate structures, the first portion of the dielectric layer contacts a third sidewall of the second gate structure, the first portion of the dielectric layer contacts the insulator layer between the first sidewall of the first gate structure and the third sidewall of the second gate structure, the second portion of the dielectric layer contacts a fourth sidewall of the third gate structure, and the second portion of the dielectric layer contacts the insulator layer between the second sidewall of the first gate structure and the fourth sidewall of the third gate structure.

In one or more tenth embodiments, further to the eighth or ninth embodiments, the dielectric structure is a first dielectric structure, the insulator layer is a first insulator layer, and also including a second insulator layer between the first insulator layer and the first interconnect metallization level, first and second source or drain regions between the first and second interconnect metallization levels, wherein the first source or drain region and the first interconnect metallization level are coupled with a first metallization structure, and the second source or drain region and the first interconnect metallization level are coupled with a second metallization structure, and a second dielectric structure between and in contact with the first and second metallization structures, wherein the second insulator layer is between the second dielectric structure and the first interconnect metallization level, the second dielectric structure is in contact with the second insulator layer between the first and second metallization structures, and a third width of the second dielectric structure between the second side of the first source or drain region and the second side of the second source or drain region is greater than a fourth width of the second dielectric structure at the second insulator layer.

In one or more eleventh embodiments, further to the eighth through tenth embodiments, the dielectric layer is a first dielectric layer, the first dielectric structure includes first and second dielectric cores, the gate structure between the first and second dielectric cores, the first portion of the first dielectric layer between the gate structure and the first dielectric core, the second portion of the first dielectric layer between the gate structure and the second dielectric core, the second dielectric structure includes a third dielectric core and a second dielectric layer, the second dielectric layer is in contact with the first and second metallization structures, the second dielectric layer is in contact with the second insulator layer between the first and second metallization structures, the first, second, and third dielectric cores are continuous on the second side of the gate structure, and the first and second dielectric layers are continuous on the second side of the gate structure.

In one or more twelfth embodiments, further to the eighth through eleventh embodiments, the dielectric structure is a first dielectric structure, the insulator layer is between first and second metallization structures, the first metallization structure on the first side of a first source or drain region, the second metallization structure on the first side of a second source or drain region, the apparatus also includes a second dielectric structure between the first and second metallization structures, between the first and second source or drain regions, and in contact with the insulator layer and the first and second metallization structures, and a third width of the second dielectric structure is between the second side of the first source or drain region and the second side of the second source or drain region and is greater than a fourth width of the second dielectric structure at the insulator layer.

In one or more thirteenth embodiments, further to the eighth through twelfth embodiments, the second dielectric structure includes the dielectric layer, and the dielectric layer is continuous between the first and second dielectric structures on the second side of the gate structure.

In one or more fourteenth embodiments, further to the eighth through thirteenth embodiments, also including third, fourth, fifth, and sixth metallization structures and third and fourth source or drain regions, wherein the third and fourth, fourth and fifth, and fifth and sixth metallization structures are each separated by a length extending in a direction, the third metallization structure is on the third source or drain region, the sixth metallization structure is on the fourth source or drain region, the dielectric structure is a first dielectric structure, the dielectric layer is a first dielectric layer, the insulator layer is a first of a plurality of first insulator layers, a second insulator layer is between the first insulator layers and the first interconnect metallization level, the second insulator layer in contact with the first insulator layers, individual ones of the plurality of first insulator layers are between the third and fourth, fourth and fifth, and fifth and sixth metallization structures, and a second dielectric structure is between the second interconnect metallization level and the third and fourth source or drain regions, the second dielectric structure including a second dielectric layer, the second dielectric layer in contact with the third and fourth source or drain regions and the fourth and fifth metallization structures.

In one or more fifteenth embodiments, further to the eighth through fourteenth embodiments, the first dielectric structure includes a first dielectric core, the second dielectric structure includes a second dielectric core, the first and second dielectric layers are continuous between the first and second dielectric structures on the second side of the gate structure, and the first and second dielectric cores are continuous between the first and second dielectric structures on the second side of the gate structure.

In one or more sixteenth embodiments, a method includes revealing first and second transistor structures on a first side of a substrate, opposite a second side of the substrate, the substrate including an interconnect metallization level on the second side, the first and second transistor structures coupled to the interconnect metallization level, forming an opening between the first and second transistor structures from the first side, wherein the opening separates first and second metallization structures, the first transistor structure includes the first metallization structure, the second transistor structure includes the second metallization structure, and the opening includes a first width on the first side of the first and second transistor structures greater than a second width on the second side of the first and second transistor structures, and forming a dielectric structure between the first and second transistor structures, wherein the dielectric structure includes the first width on the first side of the first and second transistor structures and the second width on the second side of the first and second transistor structures.

In one or more seventeenth embodiments, further to the sixteenth embodiments, the forming the dielectric structure between the first and second transistor structures includes depositing a layer of a first dielectric over the first side of the substrate, the layer of the first dielectric in contact with the first and second transistor structures between the first and second transistor structures, and depositing a second dielectric over the layer of the first dielectric, the second dielectric between the first and second transistor structures, the layer of the first dielectric between the second dielectric and the first transistor structure, and the layer of the first dielectric between the second dielectric and the second transistor structure.

In one or more eighteenth embodiments, further to the sixteenth or seventeenth embodiments, also including revealing first and second sections of the first and second metallization structures by removing at least a portion of the dielectric structure, and coupling the first and second metallization structures by depositing a metal on and between the revealed first and second sections of the first and second metallization structures.

In one or more nineteenth embodiments, further to the sixteenth through eighteenth embodiments, the forming the opening between the first and second transistor structures forms the first and second metallization structures by etching through and bisecting a shared metallization structure, the etching through and bisecting the shared metallization structure stops on an insulator layer between the first and second metallization structures and the interconnect metallization level, the first metallization structure couples a first source or drain region to the interconnect metallization level, and the second metallization structure couples a second source or drain region to the interconnect metallization level.

In one or more twentieth embodiments, further to the sixteenth through nineteenth embodiments, the forming the opening between the first and second transistor structures forms the first and second metallization structures by etching through and bisecting a shared metallization structure, the etching through and bisecting the shared metallization structure stops on an insulator layer between the first and second metallization structures and the interconnect metallization level, the first metallization structure is a first gate structure, and the second metallization structure is a second gate structure.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
first and second interconnect metallization levels on opposing first and second sides of a sub strate;
first and second transistor structures between the first and second interconnect metallization levels, wherein the first transistor structure is coupled to the first interconnect metallization level by a first metallization structure on the first side of a first source or drain region, and the second transistor structure is coupled to the first interconnect metallization level by a second metallization structure on the first side of a second source or drain region; and
a dielectric structure between the first and second metallization structures, wherein the dielectric structure is in contact with an insulator layer between the first interconnect metallization level and the first and second metallization structures, and a first width of the dielectric structure between a second side, opposite the first side, of the first source or drain region and the second side, opposite the first side, of the second source or drain region is greater than a second width of the dielectric structure adjacent to the insulator layer.

2. The apparatus of claim 1, wherein:
the dielectric structure comprises a dielectric core and a dielectric liner;
the dielectric core is in contact with first, second, and third portions of the dielectric liner;
the first portion of the dielectric liner is in contact with the first metallization structure;
the second portion of the dielectric liner is in contact with the insulator layer; and
the third portion of the dielectric liner is in contact with the second metallization structure.

3. The apparatus of one of the previous claims, wherein:
the dielectric structure is a first dielectric structure, comprising a first dielectric liner and a first dielectric core;
the apparatus further comprises a second dielectric structure, comprising a second dielectric core and a second dielectric liner;
the apparatus further comprises a third source or drain region in a third transistor structure and coupled to the first interconnect metallization level by a third metallization structure on the first side of the third source or drain region;
the second dielectric structure is between the first and third source or drain regions and in contact with the first and third metallization structures;
the first and second dielectric liners are continuous on the second side of the first source or drain region; and
the first and second dielectric cores are continuous on the second side of the first source or drain region.

4. The apparatus of one of the previous claims, wherein:
the dielectric structure is a first dielectric structure;
the insulator layer is a first insulator layer;
the first insulator layer is between a second insulator layer and the first interconnect metallization level;
the apparatus further comprises a second dielectric structure between and in contact with first and second gate structures;
the second insulator layer is between the second dielectric structure and the first interconnect metallization level;
the second dielectric structure is in contact with the second insulator layer; and
a third width of the second dielectric structure is between the second side of the first gate structure and the second side of the second gate structure and is greater than a fourth width of the second dielectric structure at the second insulator layer.

5. The apparatus of claim 4, wherein the first dielectric structure comprises a first dielectric liner and a first dielectric core, the second dielectric structure comprises a second dielectric liner and a second dielectric core, and the first and second dielectric cores are continuous on the second side of the first gate structure, and the first and second dielectric liners are continuous on the second side of the first gate structure.

6. The apparatus of one of the previous claims, wherein:
the dielectric structure is a first dielectric structure;
the insulator layer is a first insulator layer;
the first insulator layer is between a second insulator layer and the first interconnect metallization level;
the second insulator layer is between third and fourth metallization structures, the third metallization structure on the first side of a third source or drain region, the fourth metallization structure on the first side of a fourth source or drain region;
the apparatus further comprises a second dielectric structure between the third and fourth metallization structures and in contact with the second insulator layer and the third and fourth metallization structures; and
a third width of the second dielectric structure is between the second side of the third source or drain region and the second side of the fourth source or drain region and is greater than a fourth width of the second dielectric structure at the second insulator layer.

7. The apparatus of one of the previous claims, further comprising third, fourth, fifth, and sixth metallization structures and third and fourth source or drain regions, wherein:
the third and fourth, fourth and fifth, and fifth and sixth metallization structures are each separated by a length extending in a direction;
the third metallization structure is on the third source or drain region;
the sixth metallization structure is on the fourth source or drain region;
the dielectric structure is a first dielectric structure;
the insulator layer is a first insulator layer;
the first insulator layer is between the first interconnect metallization level and a plurality of second insulator layers, the second insulator layers in contact with the first insulator layer;
the second insulator layers are between the third and fourth, fourth and fifth, and fifth and sixth metallization structures; and
a second dielectric structure is between the second interconnect metallization level and the third and fourth source or drain regions, the second dielectric structure comprising a dielectric liner on a dielectric core, the dielectric liner in contact with the fourth and fifth metallization structures.

8. A method, comprising:
revealing first and second transistor structures on a first side of a substrate, opposite a second side of the substrate, the substrate comprising an interconnect metallization level on the second side, the first and second transistor structures coupled to the interconnect metallization level;
forming an opening between the first and second transistor structures from the first side, wherein the opening separates first and second metallization structures, the first transistor structure comprises the first metallization structure, the second transistor structure comprises the second metallization structure, and the opening comprises a first width on the first side of the first and second transistor structures greater than a second width on the second side of the first and second transistor structures; and
forming a dielectric structure between the first and second transistor structures, wherein the dielectric structure comprises the first width on the first side of the first and second transistor structures and the second width on the second side of the first and second transistor structures.

9. The method of claim 8, wherein the forming the dielectric structure between the first and second transistor structures comprises:
depositing a layer of a first dielectric over the first side of the substrate, the layer of the first dielectric in contact with the first and second transistor structures between the first and second transistor structures; and
depositing a second dielectric over the layer of the first dielectric, the second dielectric between the first and second transistor structures, the layer of the first dielectric between the second dielectric and the first transistor structure, and the layer of the first dielectric between the second dielectric and the second transistor structure.

10. The method of either claim 8 or 9, further comprising revealing first and second sections of the first and second metallization structures by removing at least a portion of the dielectric structure, and coupling the first and second metallization structures by depositing a metal on and between the revealed first and second sections of the first and second metallization structures.

11. The method of any one of claims 8-10, wherein:
the forming the opening between the first and second transistor structures forms the first and second metallization structures by etching through and bisecting a shared metallization structure;
the etching through and bisecting the shared metallization structure stops on an insulator layer between the first and second metallization structures and the interconnect metallization level;
the first metallization structure couples a first source or drain region to the interconnect metallization level; and
the second metallization structure couples a second source or drain region to the interconnect metallization level.

12. The method of any one of claims 8-11, wherein:
the forming the opening between the first and second transistor structures forms the first and second metallization structures by etching through and bisecting a shared metallization structure;
the etching through and bisecting the shared metallization structure stops on an insulator layer between the first and second metallization structures and the interconnect metallization level;
the first metallization structure is a first gate structure; and
the second metallization structure is a second gate structure.
